# EUROPÄISCHE PATENTSCHRIFT

(11) **EP 4 699 719 B1**
(45) Veröffentlichungstag und Bekanntmachung des Hinweises auf die Patenterteilung: **21.10.2026**
(21) Anmeldenummer: 24208633.8
(22) Anmeldetag: 24.10.2024
(51) Int. Cl.: B21J 15/32, B23P 19/00, B23P 19/06, B25B 13/48, B25B 23/04

(54) **ZUFÜHRVORRICHTUNG FÜR FÜGEELEMENTE, SETZWERKZEUG MIT DER ZUFÜHRVORRICHTUNG UND DAZUGEHÖRIGES ZUFÜHR- UND SETZVERFAHREN**
SUPPLY DEVICE FOR JOINING ELEMENTS, SETTING TOOL WITH THE SUPPLY DEVICE AND ASSOCIATED SUPPLY AND SETTING METHOD
DISPOSITIF D'ALIMENTATION POUR ÉLÉMENTS D'ASSEMBLAGE, OUTIL DE POSE AVEC LE DISPOSITIF D'ALIMENTATION ET PROCÉDÉ D'ALIMENTATION ET DE POSE ASSOCIÉ

(30) Priorität: 20.08.2024 EP 24195296
(43) Veröffentlichungstag der Anmeldung: 25.02.2026
(73) Patentinhaber: Böllhoff Verbindungstechnik GmbH, 33649 Bielefeld (DE)
(72) Erfinder: Ahlemeyer, Fabian, 33334 Gütersloh (DE); Haesler, Bernd, 33790 Halle (DE); Doedtmann, Kilian, 49565 Bramsche (DE); Roeschert, Benjamin, 33189 Schlangen (DE); Schienstock, Oliver, 33129 Delbrück (DE)
(74) Vertreter: HWP Intellectual Property

(56) Entgegenhaltungen:
- WO-A2-2011/029817
- DE-A1- 102018 123 215
- US-B2- 7 331 098

## Beschreibung

### 1. Gebiet der Erfindung

Die vorliegende Erfindung betrifft eine Zuführvorrichtung für Fügeelement, ein Setzwerkzeug mit der Zuführvorrichtung sowie ein Zuführverfahren unter Verwendung der Zuführvorrichtung.

### 2. Hintergrund der Erfindung

Vorrichtungen und Verfahren zum Setzen von Fügeelementen wie Nieten sind dem Fachmann allgemein bekannt. Üblicherweise ist bei einer entsprechenden Vorrichtung ein Setzwerkzeug auf einem C-Rahmen als Trägerkonstruktion montiert. Der C-Rahmen kann an einem Roboterarm befestigt sein, sodass zahlreiche automatische Vorgänge an den erforderlichen Stellen durch den Roboter ausgeführt werden können.

Vor dem Setzvorgang müssen die Fügeelemente von einer Fügeelementquelle zu einer Position unterhalb des Stempels im Setzkopf des Setzwerkzeugs befördert werden. Dies erfolgt typischerweise durch einen flexiblen Profilschlauch. Die Fügeelemente können somit mittels Druckluft und/oder Schwerkraft dem Setzgerät zugeführt werden.

Die Zufuhr der Fügeelemente erfolgt dabei einzeln oder in Gruppen und erfordert einen oder mehrere Handhabungsmechanismen entlang der Zuführung, sodass nur das oder die benötigten Fügeelemente bei Bedarf zugeführt werden.

Hierzu ist beispielsweise aus WO 2006/084847 A1 bekannt, Verbindungselemente von einem Zuführgerät in gleicher Ausrichtung aufgereiht bereitzustellen und durch einen Förderkanal zu einer an dem Verarbeitungsgerät angeordneten Ladevorrichtung unmittelbar benachbart zu einer Verarbeitungsposition des Fügeelements unter dem Stempel zu fördern. Die Förderung der Verbindungselemente erfolgt in einzelnen Förderschritten, die einen zeitlichen Abstand voneinander haben. Bei jedem Förderschritt wird eine Säule aus mehreren Verbindungselementen, die gleichgerichtet mit ihren parallelen Begrenzungsflächen aneinander liegen, durch Einleiten von Luft in den Förderkanal von dem Zuführgerät zur Ladevorrichtung am Verarbeitungsgerät gefördert. Das Zuführen von der Ladevorrichtung zu der Verarbeitungsposition unter dem Stempel erfolgt über einen starren Ladeschieber, der mittels eines pneumatisch angetriebenen Kolbens in einem Ladekanal hin- und her bewegbar ist.

Eine ähnliche Lösung ist aus WO 2010/139514 A1 bekannt. Hierin ist ein Vereinzelungsschieber für eine Vorrichtung zum Zuführen eines Verbindungselements beschrieben. Der Vereinzelungsschieber weist ein in einer axialen Richtung verlaufendes Durchgangsloch zum Aufnehmen des Verbindungselements auf. Das Durchgangsloch ist mindestens von zwei Schenkelsegmenten gebildet. Der Vereinzelungsschieber ist des Weiteren einstückig ausgebildet und weist ein Grundsegment auf. Ein Übergang von dem Grundsegment zu jedem der Schenkelsegmente ist so ausgebildet, dass eine Elastizität des entsprechenden Schenkelsegments in radialer Richtung bereitgestellt ist. Des Weiteren werden eine Vorrichtung zum Zuführen eines Verbindungselements in eine Verarbeitungsposition und ein Verfahren beschrieben.

In diesem Zusammenhang sind dem Fachmann ebenfalls Lösungen bekannt, bei denen die korrekte Positionierung des Fügeelements in der Verarbeitungsposition mittels eines flexiblen Stö-βels erfolgt, der in einem eigenen Kanal angeordnet ist. So beschreibt DE 44 00 350 A1 ein Bolzenschweißgerät, das einen Bolzenhalter mit einer Bolzenzuführ- und Positioniereinrichtung, die an eine Schweißstromquelle anschließbar ist, und eine Stelleinrichtung umfasst, mittels derer der Bolzenhalter auf ein Werkstück zu und von diesem weg bewegbar ist. Die Regeleinrichtung besteht aus einem im Gebrauch gestellfest montierten Primärteil und einem dazu linear verschiebbaren Sekundärteil, der über ein elektrisch isolierendes Verbindungsstück die Bolzenzuführ- und Positioniereinrichtung trägt, an der der Bolzenhalter befestigt ist. Im Verstellweg der Bolzenzuführ- und Positioniereinrichtung und des Bolzenhalters ist ein mit der Bolzenzuführ- und Positioniereinrichtung zusammenwirkender Stößel gestellfest angeordnet. Ein solcher Stößel kann flexibel sein und durch einen winkelförmigen Seitendurchgang eindringen.

Um eine Vorrichtung zum Zuführen von länglichen Befestigungsmitteln zu einem Befestigungsgerät, wobei die Befestigungsmittel vereinzelt durch einen ersten Kanal zugeführt und durch einen in einem weiteren, zweiten Kanal geführten Stößel in eine Spannzange gedrückt werden, zu schaffen, bei der auch bei der Zuführung kurzer Befestigungsmittel eine ordnungsgemäße und störungsfreie Zufuhr zum Haltemittel gewährleistet ist, schlägt DE 37 39 944 C1 vor, dass der erste Kanal geradlinig durch die Vorrichtung bis zum koaxial dazu angeordneten Haltemittel verläuft, der zweite Kanal spitzwinklig in den ersten Kanal einmündet, und der Stößel flexibel ausgebildet ist. Der Stößel ist in der einen Endlage außerhalb des ersten Kanals angeordnet und in der vorgeschobenen Bolzenzuführlage, die der zweiten Endlage entspricht, ist er teils in dem zweiten und teils in dem ersten Kanal angeordnet.

Neben diesen Systemen, in denen ein Zufuhr mittels eines starren Kolbens oder eines flexiblen Stößels vorgenommen wird, sind Systeme bekannt, bei denen die Zufuhr ausschließlich mittels Druckluft erfolgt.

Ein Beispiel für ein solches System findet sich in EP 4 129 592 A1. Die hierin beschriebene Zuführeinrichtung zum Zuführen von Nägeln zu einem Nagelsetzgerät weist eine Schlauchleitung mit einem vorderen Anschluss zum Anbringen an ein Nagelsetzgerät und mindestens einen hinteren Anschluss zum Anbringen an eine Bereitstellungseinheit für Nägel auf. Durch die Schlauchleitung können Nägel in ihrer Längsrichtung hintereinander dem Nagelsetzgerät zugeführt werden. Des Weiteren ist ein Nagelsetzgerät beschrieben, insbesondere ein Druckluftnagler, sowie eine Anordnung umfassend ein Nagelsetzgerät und eine Zuführeinrichtung.

Eine Befestigungselement-Zuführvorrichtung zum automatischen Auswählen und Zuführen von Befestigungselementen, wie beispielsweise Nieten, zu einem Setzwerkzeug ist ebenso in EP 1 297 917 A2 beschrieben. Die Befestigungselemente sind in einer Verpackung vorgeladen und werden über mindestens ein Befestigungselement-Zufuhrrohr abgegeben, das das Setzgerät mit einer Befestigungselement-Zufuhrvorrichtung verbindet. Die Befestigungselement-Zuführvorrichtung gibt ausgewählte Befestigungselemente aus der Packung in das Ausgaberohr frei. Im Rohr sind die Verbindungselemente einzeln oder in Gruppen von der Zuführeinrichtung zum Werkzeug transportierbar. Eine an dem Werkzeug oder dem Förderrohr angebrachte Übergabestation übergibt ein Befestigungselement von der Fördervorrichtung in das Werkzeug. Die Übergabestation ist zwischen einer ersten Position, in der sich ein Ausgang der Übergabestation neben dem Werkzeug befindet, so dass ein zugeführtes Befestigungselement durch die Übergabestation in das Werkzeug eingesetzt werden kann, und einer zweiten Position beweglich, in der sie vom Werkzeug entfernt ist, um es dem Werkzeug oder einem Teil davon zu ermöglichen, sich in Richtung eines Werkstücks zu bewegen, um ein geladenes Befestigungselement einzusetzen. Das Förderrohr ist mit verschleißfesten Elementen versehen.

Schließlich sind dem Fachmann Vorrichtungen bekannt, die anstelle von Druckluft mechanische Elemente zur Zufuhr der Fügeelemente verwenden. Dies dient beispielsweise dazu, die mit den flexiblen Profilschläuchen verbundenen Nachteile zu vermeiden, die bei der Verwendung von Druckluft zur Zufuhr der Fügeelemente erforderlich sind.

So beschreibt WO 2019/110990 A2 ein Nietzufuhrsystem zum Zuführen von Nieten zu einem Nietsetzwerkzeug, das einen Stempel, eine ausfahrbare Nasenanordnung und eine Matrize umfasst. Das Nietzufuhrsystem umfasst mindestens eine Nietzufuhrschiene zum Zuführen der Niete zur Nasenanordnung, mindestens eine Niettransfervorrichtung zum Halten oder Freigeben der in der Nietaufnahmezone aufgenommenen Niete und mindestens ein nachfüllbares Magazin zum Aufbewahren der Niete in der Nähe des Setzwerkzeugs. Das Magazin umfasst zumindest einen Magazinabschnitt der Nietzufuhrschiene. Die Niete können im Magazin gespeichert oder durch das Magazin transportiert werden, um an das Setzwerkzeug geliefert zu werden. Das Magazin umfasst außerdem mindestens eine Anschlussschnittstelle zum Nachfüllen des Magazins, beispielsweise aus einer Massenzufuhr. Das Magazin steht mit der Nasenanordnung in Nietversorgungsbeziehung, so dass es dem Setzwerkzeug bei Bedarf Niete zuführen kann, und ist zusammen mit der Nasenanordnung beweglich. Somit sind für die Förderung der Niete vom Magazin zum Setzgerät keine langen flexiblen Förderschläuche mehr erforderlich und die Versorgung kann kontinuierlich gewährleistet werden.

Ein Magazin eines Setzgeräts zum Speichern und Zuführen einer Mehrzahl von Fügeelementen, insbesondere Setzbolzen, ein Bereitstellungsmodul für Fügeelemente und ein Setzgerät in Kombination mit diesen Elementen ist in WO 2010/043362 A2 beschrieben. Das Magazin weist ein Basiselement innerhalb des Setzgeräts mit einer Speichernut auf, in der die Fügeelemente ausgerichtet und gemeinsam bewegbar aufnehmbar sind und deren eines Ende in ein Kopfstück des Setzgeräts mündet. Weiterhin ist ein Vorschubmechanismus vorgesehen, mit dem die Fügeelemente innerhalb der Speichernut zu dem Kopfstück des Setzgeräts bewegbar sind. Schließlich weist das Magazin einen Abgabemechanismus auf, mit dem die Fügeelemente einzeln aus der Speichernut dem Kopfstück des Setzgeräts zuführbar sind.

US 7 331 098 B2 bildet die Basis für den Oberbegriff des Anspruchs 1.

Ausgehend von diesem bekannten Stand der Technik ist es eine Aufgabe der vorliegenden Erfindung, eine alternative Zuführvorrichtung für Fügeelemente bereitzustellen, bei der das Fügeelement ohne Hilfe von Druckluft durch einen, vorzugsweise profilierten, Zuführschlauch oder - kanal in jeder Raumlage, d.h. auch gegen die Schwerkraft, verlässlich zu einer gewünschten Position zugeführt wird. Ebenso ist es eine Aufgabe, ein entsprechendes Setzwerkzeug sowie ein dazugehöriges Zuführverfahren anzugeben. Schließlich ist es eine Aufgabe ein Setzverfahren zum Einbringen des Fügeelements in mindestens ein Bauteil bereitzustellen.

### 3. Zusammenfassung der Erfindung

Die obige Aufgabe wird gelöst durch eine Zuführvorrichtung gemäß dem unabhängigen Patentanspruch 1, ein Setzwerkzeug zum Setzen von Fügeelementen gemäß dem abhängigen Patentanspruch 14, ein Zuführverfahren unter Verwendung der Zuführvorrichtung gemäß dem unabhängigen Patentanspruch 16 sowie ein Setzverfahren unter Verwendung der Zuführvorrichtung gemäß dem unabhängigen Patentanspruch 17. Vorteilhafte Ausführungsformen und Weiterentwicklungen ergeben sich aus der nachfolgenden Beschreibung, den Zeichnungen sowie den anhängigen Patentansprüchen.

Eine erfindungsgemäße Zuführvorrichtung für Fügeelemente umfasst einen Aufnahmebereich für mindestens ein Fügeelement, in dem ein Fügeelement aufnehmbar und vor einer ersten Öffnung positionierbar ist, einen umfänglich geschlossenen Schlauch aus einem flexiblen Material, der an einem ersten Ende mit dem Aufnahmebereich und an einem gegenüberliegenden zweiten Ende mit einem Abgabebereich verbunden ist, sowie ein flexibles Schubelement, das mit einem Antriebsmittel durch den Schlauch zwischen einer eingefahrenen Position, in der sich ein vorderes Ende des Schubelements im Aufnahmebereich befindet, und einer ausgefahrenen Position, in der sich das vordere Ende des Schubelements im Abgabebereich befindet, hin und her bewegbar ist, so dass das vor der ersten Öffnung positionierte Fügeelement mit dem Schubelement aus dem Aufnahmebereich durch den Schlauch in den Abgabebereich schiebbar ist.

Zur besseren Nachvollziehbarkeit wird die erfindungsgemäße Zuführvorrichtung anhand der Verwendung in Kombination mit einem Setzwerkzeug erläutert. Das Setzwerkzeug umfasst beispielsweise einen Setzkopf mit einem Stempel sowie eine gegenüber dem Stempel angeordnete Matrize. Das Setzwerkzeug ist an einem C-Rahmen als Träger montiert, der beispielsweise robotergeführt bewegbar ist. Weiterhin ist eine Fügeelementquelle vorhanden, wobei es sich bei den Fügeelementen beispielsweise um Niete handelt. Alternativ handelt es sich bei den Fügeelementen um Schrauben, was später in Verbindung mit einer bevorzugten Ausführungsform diskutiert wird.

Die Fügeelemente werden von der Fügeelementquelle dem Aufnahmebereich der erfindungsgemäßen Zuführvorrichtung zugeführt. Dabei können die Fügeelemente bereits einzeln zugeführt werden oder es wird eine Mehrzahl von Fügeelementen bereitgestellt. Sofern das Fügeelement bzw. eines der Fügeelemente bei einer Mehrzahl von Fügeelementen noch nicht vor der ersten Öffnung im Aufnahmebereich positioniert ist, erfolgt zunächst das entsprechende Positionieren des Fügeelements vor der ersten Öffnung. Dies wird später verdeutlicht.

Nun wird das im Aufnahmebereich vorhandene flexible Schubelement, dass sich in der eingefahrenen Position befindet, durch die erste Öffnung in Richtung des Abgabebereichs bewegt. Dies erfolgt über das Antriebsmittel. Im Rahmen dieser Bewegung schiebt das flexible Schubelement das Fügeelement vor sich her, aus dem Aufnahmebereich heraus und in den Schlauch hinein. Bei der Verwendung von Nieten oder dergleichen als Fügeelement greift das flexible Schubelement das Fügeelement quer zur Längsachse des Fügeelements an. Um sicherzustellen, dass das Fügeelement in diesem Zusammenhang im Schlauch nicht verkantet, ist der Schlauch als Profilschlauch ausgeführt.

Entsprechende Profilschläuche sind aus dem Bereich der Druckluftzufuhr von Fügeelementen bekannt. Diese sind umfänglich geschlossen ausgebildet und weisen im Inneren eine Querschnittsform auf, die der Querschnittsform des zu befördernden Fügeelements entspricht, d.h. beispielsweise T-förmig ist.

Der Schlauch verbindet den Aufnahmebereich, der sich entfernt vom Setzkopf befindet, beispielsweise an dem Roboterarm, mit dem Abgabebereich, der benachbart zum Setzkopf des Setzwerkzeugs angeordnet ist. Aufgrund dieses Abstands und der verschiedenen Positionen, die das Setzwerkzeug im Raum aufgrund der Roboterführung einnehmen kann, weist der Schlauch in der Regel einen krummlinigen Verlauf auf, d.h. eine Vielzahl an Kurven und Biegungen. Um das Fügeelement daher mit dem Schubelement durch den Schlauch zu dem Abgabebereich zu befördern, muss das Schubelement dem Verlauf des Schlauchs folgen können. Aus diesem Grund ist das Schubelement gemäß der vorliegenden Erfindung flexibel ausgeführt.

Aufgrund der voneinander entfernten Anordnung beträgt eine Länge des Schlauchs vorzugsweise mindestens 50 cm, vorzugsweise mindestens 60 cm und besonders bevorzugt mindestens 70 cm. Hierdurch wird deutlich, dass der Aufnahmebereich im Vergleich zum Stand der Technik gerade nicht unmittelbar benachbart zum Setzkopf angeordnet ist.

Sobald das Fügeelement den Abgabebereich passiert hat, wird es in dem zugrunde liegenden Beispiel an den Setzkopf abgegeben. In anderen Beispielen kann die Zuführvorrichtung allgemein dazu verwendet werden, Fügeelemente von einer ersten Position zu einer entfernten zweiten Position zu befördern. Mit anderen Worten kann die Zuführvorrichtung auch in einem anderen Abschnitt der Zuführung zwischen der Fügeelementquelle und einer Verarbeitungs- oder Weiterverarbeitungsposition des Fügeelements eingesetzt werden. Dies kann auch bei der Verwendung von Schrauben als Fügeelement besonders vorteilhaft sein, was später unter Bezugnahme auf eine bevorzugte Ausführungsform verdeutlicht wird.

Ein allgemeiner Vorteil dieser Vorrichtung ist, dass keine Pneumatik-Komponenten benötigt werden, um ein Fügeelement von einer ersten Position, d.h. dem Aufnahmebereich, zu einer zweiten Position zu bewegen, d.h. dem Abgabebereich. Dies wirkt sich vorteilhaft im Hinblick auf die entstehenden Kosten sowie die Nachhaltigkeit aus. Dabei stellt gerade die Verwendung des flexiblen Schubelements sicher, dass das Fügeelement in jeder Raumlage, d.h. auch gegen die Schwerkraft, verlässlich von dem Aufnahmebereich zu dem Abgabebereich befördert wird.

In einer bevorzugten Ausführungsform der Zuführvorrichtung umfasst der Aufnahmebereich weiterhin ein Vereinzelungsmittel, um ein Fügeelement von einer Mehrzahl an Fügeelementen zu trennen und vor der ersten Öffnung zu positionieren, vorzugsweise ein mechanisches Vereinzelungsmittel. Dies ist besonders vorteilhaft, wenn dem Aufnahmebereich eine Mehrzahl von Fügeelementen bereitgestellt wird. Dies ist beispielsweise der Fall, wenn der Aufnahmebereich mit einer Staustrecke für Fügeelemente oder einem Fügeelementmagazin verbunden ist.

Das Vereinzelungsmittel stellt hierbei sicher, dass immer nur ein einzelnes Fügeelement von dem Aufnahmebereich zu dem Abgabebereich durch den Schlauch gefördert wird. Um auch an dieser Stelle den Einsatz von Pneumatik-Komponenten zu vermeiden, handelt es sich bei dem Vereinzelungsmittel insbesondere um ein mechanisches Vereinzelungsmittel, wie einen mechanisch betätigten Schieber oder dergleichen.

Vorteilhafterweise umfasst das Schubelement eines der folgenden: einen Federstab, vorzugsweise einen auf Block gewickelten Federstab, einen Elastomer-Stab, einen Gliederstrang, ein Stahlseil, einen Bowdenzug oder ein drucksteifes Federblech. Durch die Auswahl des Schubelements kann die Zuführvorrichtung optimal an den jeweiligen Anwendungsfall angepasst werden, beispielsweise im Hinblick auf den zur Verfügung stehenden Raum. Grundsätzlich kommt als Schubelement jedes Element in Frage, das einem krummlinigen Verlauf des Schlauchs zwischen dem Aufnahmebereich und dem Abgabebereich folgen kann. Dabei ist zu beachten, dass das Schubelement sich bei Druck möglichst nicht oder nur wenig komprimiert, um eine ordnungsgemäße Beförderung des Fügeelements zum Abgabebereich sicherzustellen. In diesem Zusammenhang ist gerade die bevorzugte Länge des Schlauchs von mindestens 50 cm zu beachten. Denn das Schubelement muss ebenfalls mindestens diese Länge aufweisen, um das Fügeelement von dem Aufnahmebereich zu dem Abgabebereich zu befördern. Dies kann besonders vorteilhaft aufgrund des auf Block gewickelten Federstabs erreicht werden, was später verdeutlicht wird.

Gemäß einer weiteren bevorzugten Ausführungsform der Zuführvorrichtung ist der Schlauch ein Profilschlauch und das Schubelement umfasst eine Haltevorrichtung für das Fügeelement benachbart zu dem vorderen Ende des Schubelements, insbesondere ein Formstück oder zwei Haltearme. In diesem Zusammenhang ist es besonders bevorzugt, dass die Haltevorrichtung ein Formstück umfasst, das eine Außenkontur aufweist, die passend zu einer Kontur des Fügeelements und/oder zu einer Innenkontur des Profilschlauchs ausgestaltet ist, und/oder sich an einem dem Schubelement zugewandten Ende verjüngt. Wie eingangs im Hinblick auf Niete als beispielhafte Fügeelemente angedeutet, ist diese Ausführungsform darauf gerichtet, dass das Schubelement das Fügeelement seitlich angreift, d.h. quer zu einer Längsachse des Fügeelements. Aus diesem Grund ist auch die Verwendung eines Profilschlauchs als Schlauch erforderlich, um ein Verkanten oder Verkippen des Fügeelements im Schlauch zu vermeiden.

Aufgrund der am Schubelement vorgesehen Haltevorrichtung ist sichergestellt, dass das Fügeelement an dem Schubelement anliegt, sich also auch aufgrund der Schwerkraft möglichst nicht von dem Schubelement entfernt. Diese Funktion wird besonders durch ein entsprechend angepasstes Formstück unterstützt. Zudem wirkt sich diese Ausgestaltung vorteilhaft in Abhängigkeit von der gewählten Überwachungsart für die ordnungsgemäße Beförderung des Fügeelements zu dem Abgabebereich aus, was später erläutert wird.

Die verjüngte Ausgestaltung des Formstücks an dem dem Schubelement zugewandten Ende bewirkt, dass bei einem Rückhub des Schubelements, d.h. bei einer Bewegung von der ausgefahrenen in die eingefahrene Position, das Schubelement möglichst reibungsarm durch den als Profilschlauch ausgebildeten Schlauch gezogen werden kann, gerade bei einem krummlinigen Verlauf des Profilschlauchs. Ohne die verjüngte Ausgestaltung könnte sich, beispielsweise bei Verwendung eines Federstabs als Schubelement, das Schubelement zunächst längen und dann plötzlich zurückschnellen, sobald die Kraft erreicht wird, die erforderlich ist, um die Klemmstelle zu überwinden.

In einer weiteren bevorzugten Ausführungsform der Zuführvorrichtung weist das Schubelement benachbart zu dem vorderen Ende ein Übertragungsmittel auf, das mit einem Kopf des Fügeelements in Eingriff bringbar ist, sodass eine Rotation des Schubelements auf das Fügeelement übertragbar ist. Diese Ausgestaltung ist insbesondere auf die Verwendung von Schrauben als Fügeelement gerichtet. Diese weisen an ihrem Kopfende eine innere und/oder äußere Form auf, die den Eingriff eines Werkzeugs gestattet, um das als Schraube ausgebildete Fügeelement zu drehen. Um mit dieser Form in Eingriff zu gelangen, weist das Schubelement das entsprechend gestaltete Übertragungsmittel auf. Im Unterschied zu dem vorherigen Beispiel greift das Schubelement das Fügeelement somit nicht quer zur Längsachse des Fügeelements an, sondern entlang der Längsachse des Fügeelements. Die Verwendung eines Profilschlauchs als Schlauch ist somit nicht möglich.

Zudem ist das Schubelement, das vorzugsweise als eine flexible Welle ausgebildet ist, mit einem zweiten Antriebsmittel versehen, das das Schubelement in Rotation versetzt. Die Rotation des Schubelements lässt sich auf das Fügeelement übertragen, so dass die Schraube als Fügeelement in mindestens ein Bauteil, vorzugsweise in mindestens zwei Bauteile, geschraubt werden kann.

Während der Verwendung wird die Schraube als Fügeelement somit in der oben beschriebenen Weise von dem Aufnahmebereich durch den Schlauch zu dem Abgabebereich geschoben. Vorzugsweise ist der Abgabebereich dabei nicht an einem Setzkopf eines Setzwerkzeugs angeordnet, sondern endet an einem Bauteil, liegt also beispielsweise auf diesem auf. Nachdem das Schubelement das Fügeelement durch den Schlauch geschoben hat, liegt somit eine Spitze des Fügeelements an dem ersten Bauteil an. Aufgrund der vorzugsweise starren Ausgestaltung des Abgabebereichs ist das Fügeelement zudem in radialer Richtung sicher positioniert.

Wird nun das zweite Antriebsmittel betätigt, dann versetzt dieses das Schubelement in Rotation, die über das Übertragungsmittel auf das Fügeelement übertragen wird. Somit kann das Fügeelement in mindestens das erste Bauteil gesetzt werden. Vorzugsweise überträgt das Schubelement dabei ein Drehmoment zwischen 3 Nm und 30 Nm, vorzugsweise bis 15 Nm.

Vorteilhafterweise ist das Schubelement im eingefahrenen Zustand zumindest teilweise auf einer Trommel aufgewickelt oder in einem Gehäuse angeordnet. Durch diese Ausgestaltung kann dem jeweiligen Anwendungserfordernis weiter Rechnung getragen werden, gerade in Verbindung mit der Auswahl des geeigneten Schubelements. In dieser Hinsicht wird auf die obigen Ausführungen zu den verschiedenen bevorzugten Schubelement-Arten verwiesen.

Im Hinblick auf die Dimensionierung ist es besonders bevorzugt, dass das Schubelement eine Querschnittsfläche aufweist, die zwischen 30 und 80 % der Querschnittsfläche des Schlauchs liegt. Dies gilt insbesondere bei Verwendung eines Profilschlauchs als Schlauch. Die Querschnittsfläche des Schubelements errechnet sich basierend auf dem Außendurchmesser bzw. den äußeren Abmessungen des Schubelements, unabhängig von seiner tatsächlichen Gestaltung. Hierdurch wird insbesondere sichergestellt, dass sich das Schubelement nicht im "Zick-Zack" an einer Innenwand des Profilschlauchs anlegt. Denn dies würde zu einer Abweichung zwischen der Länge des Profilschlauchs und einer Länge des Schubelements im Profilschlauch führen. Diese Länge ist jedoch wichtig, damit das Fügeelement ordnungsgemäß zum Abgabebereich befördert und, sofern erforderlich, diesen passiert sowie die tatsächliche Position auch korrekt erfasst wird. Somit wird hierdurch auch eine Überwachung der ordnungsgemäßen Beförderung des Fügeelements verbessert, was später ebenfalls erläutert wird.

Vorteilhafterweise umfasst das Antriebsmittel einen elektrischen, pneumatischen oder hydraulischen Aktor. Gerade die Verwendung eines elektrischen Aktors ist besonders bevorzugt, da auf diese Weise die Zuführvorrichtung ohne jegliche Pneumatik-Komponenten auskommt. Zusätzlich wichtig bei der Wahl des Aktors können die bereits an dem Setzwerkzeug oder dem Einsatzort zur Verfügung stehenden Betriebsmittel sein. So könnte auf ein bereits bestehendes Versorgungsnetz mit Druckluft oder dergleichen zugegriffen und als Aktor ein pneumatischer Aktor oder ein hydraulischer Aktor gewählt werden.

Weiterhin ist es bevorzugt, dass das Antriebsmittel zwei Räder umfasst, zwischen denen das Schubelement geführt ist und von denen mindestens eines angetrieben ist. In diesem Zusammenhang ist es vorteilhaft, dass mindestens eines der zwei Räder eine Rändelung, Elastomer-Beschichtung oder einen Elastomer-Ring aufweist, vorzugsweise beide Räder, und/oder ein Rad in Richtung des anderen Rades vorgespannt angeordnet ist, insbesondere federvorgespannt. Gerade die Außenkontur und der Werkstoff des Antriebsrades oder der Räder, aber auch die vorgespannte Anordnung sorgen dafür, dass im Kontaktbereich mit dem Schubelement eine möglichst hohe Reibung erzeugt wird. Auf diese Weise wird eine Relativbewegung zwischen den Rädern und dem Schubelement vermieden, was sich positiv auf die ordnungsgemäße Funktion der Zuführvorrichtung auswirkt.

In einer vorteilhaften Ausführungsform umfasst die Zuführvorrichtung weiterhin mindestens einen der folgenden Sensoren: einen Wegsensor, einen Kraftsensor, einen Drehmomentsensor und/oder einen Geschwindigkeitssensor. Die jeweiligen Sensoren sind gerade in Kombination mit zwei Rädern als Antriebsmittel besonders bevorzugt. Beispielhaft wird die Verwendung der Sensoren in Verbindung mit einem Federstab als Schubelement sowie bei Verwendung eines Wegsensors und somit einer Wegsteuerung erläutert.

Dabei ist zunächst zu beachten, dass gerade bei einer weggesteuerten Zufuhr des Fügeelements von dem Aufnahmebereich zu dem Abgabebereich das Schubelement möglichst nicht gestaucht werden darf. Dies kann beispielsweise darüber erreicht werden, dass als Schubelement ein auf Block gewickelter Federstab verwendet wird.

Auch bei einer kraftgesteuerten Variante würde eine Stauchung des Schubelements zu Problemen führen, da der Kraftanstieg stark abgeschwächt bzw. verzögert am Antriebsmittel und einem dort verwendeten Kraftsensor ankäme.

Um dies zu vermeiden, könnte alternativ oder zusätzlich ein Positionssensor verwendet werden. Denn gerade dieser erkennt, ob das Fügeelement die gewünschte Position im oder in Zuführrichtung hinter dem Abgabebereich, beispielsweise benachbart zum oder unterhalb des Stempels des Setzkopfs, erreicht hat.

Bei der beispielhaften Wegsteuerung detektiert der Wegsensor nach jedem Rückhub, dass das Schubelement wieder in der eingefahrenen Position ist. Hier wird der Weg also vor jedem neuen Zuführvorgang genullt. Die zurückzulegende Strecke beim Vorhub wird beispielsweise über die Umdrehungen der Motorwelle definiert. Eine Umrechnung der Umdrehungen der Motorwelle in den zurückgelegten Weg des Schubelements erfolgt über den Wirkdurchmesser des Antriebsrades.

Alternativ wird das Drehmoment des Motors und die Reibung des Antriebsrades so gewählt, dass der Motor stehen bleibt, wenn das Fügeelement im oder in Zuführrichtung hinter dem Abgabebereich an der gewünschten Position, beispielsweise im Setzkopf, angekommen ist und das Schubelement nicht weitergeschoben werden kann. Dieser Zustand kann beispielsweise auch mit einem Geschwindigkeitssensor erfasst werden, da die Ist-Geschwindigkeit des Schubelements in diesem Fall null ist.

Ein erfindungsgemäßes Setzwerkzeug zum Setzen von Fügeelement umfasst die erfindungsgemäße Zuführvorrichtung. Das erfindungsgemäße Setzwerkzeug verwendet somit für die Zufuhr der Fügeelemente die erfindungsgemäße Zuführvorrichtung. Im Hinblick auf die sich daraus ergebenden technischen Effekte und Vorteile wird auf die obigen Ausführungen zur Zuführvorrichtung verwiesen, um Wiederholungen zu vermeiden.

In einer bevorzugten Ausführungsform des Setzwerkzeugs sind der Abgabebereich benachbart zu einem Setzkopf des Setzwerkzeugs und der Aufnahmebereich entfernt von dem Setzkopf angeordnet, so dass das Fügeelement durch den Abgabebereich an das Setzwerkzeug, insbesondere an den Setzkopf des Setzwerkzeugs, abgebbar ist. Im Rahmen dieser Ausgestaltung stellt die Zuführvorrichtung den letzten Abschnitt der Zuführung zum Setzkopf bereit. Da die Zuführvorrichtung keine Pneumatik-Komponenten für die Zufuhr des Fügeelements zum Setzkopf benötigt, kann somit eine druckluftfreie Zufuhr realisiert werden.

Alternativ zu dieser bevorzugten Ausführungsform kann die Zuführvorrichtung auch so verwendet werden, dass mit dieser beispielsweise eine Schraube als Fügeelement in ein Bauteil eingebracht oder gesetzt wird. Hierzu weist das Schubelement das Übertragungsmittel auf, das mit dem Kopfende des Fügeelements in Eingriff bringbar ist. Auf diese Weise überträgt sich eine auf das Schubelement aufgebrachte Drehbewegung auf die Schraube als Fügeelement, so dass diese in das Bauteil oder eine Mehrzahl an Bauteilen geschraubt wird. Bezüglich der Details wird auf die Erläuterungen zu der entsprechenden oben diskutierten bevorzugten Ausführungsform verwiesen.

Ein erfindungsgemäßes Zuführverfahren unter Verwendung der erfindungsgemäßen Zuführvorrichtung umfasst die Schritte: Zuführen eines Fügeelements zu dem Aufnahmebereich der Zuführvorrichtung, Positionieren des Fügeelements vor der ersten Öffnung im Aufnahmebereich, wodurch das Fügeelement vor einem flexiblen Schubelement angeordnet ist, Bewegen des Schubelements von einem eingefahrenen Zustand in einen ausgefahrenen Zustand, wodurch das vor dem Schubelement positionierte Fügeelement in Richtung des Abgabebereichs durch den Schlauch bewegt wird, Abgeben des Fügeelements bei Erreichen des Abgabebereichs und Zurückbewegen des flexiblen Schubelements von der ausgefahrenen in die eingefahrene Position. Das erfindungsgemäße Zuführverfahren verwendet zur Zufuhr des Fügeelements die erfindungsgemäße Zuführvorrichtung. Daher wird auch in dieser Hinsicht auf die obigen Ausführungen verwiesen, um Wiederholungen zu vermeiden. Vorzugsweise wird das Zuführverfahren in Verbindung mit einem Setzwerkzeug genutzt, so dass, wie oben erläutert, die Zuführvorrichtung den letzten Abschnitt der Zufuhr von Fügeelementen zum Setzkopf des Setzwerkzeugs realisiert. In Abhängigkeit von den gewünschten Funktionen und der gewünschten Abstimmung der Fügeelementzufuhr kann das Zuführverfahren von einer der Zuführvorrichtung zugeordneten Steuerung, einer dem Setzwerkzeug zugeordneten Steuerung oder einer dem Roboter zugeordneten Steuerung ausgeführt werden. Gerade die der Zufuhrvorrichtung zugeordnete Steuerung kann dabei einer dem Setzwerkzeug zugeordneten Steuerung untergeordnet sein.

Ein erfindungsgemäßes Setzverfahren verwendet eine Ausführungsform der erfindungsgemäßen Zuführvorrichtung, wobei das Schubelement das Übertragungsmittel aufweist, das mit einem Kopf des Fügeelements in Eingriff bringbar ist. Das Setzverfahren umfasst die Schritte: Zuführen eines Fügeelements zu dem Aufnahmebereich der Zuführvorrichtung, Positionieren des Fügeelements vor der ersten Öffnung im Aufnahmebereich, wodurch das Fügeelement vor dem flexiblen Schubelement angeordnet ist, Bewegen des Schubelements von einem eingefahrenen Zustand in einen ausgefahrenen Zustand, wodurch das vor dem Schubelement positionierte Fügeelement in Richtung des Abgabebereichs durch den Schlauch bewegt wird, Aufbringen eines Drehmoments auf das Fügeelement über das Übertragungsmittel am vorderen Ende des Schubelements mittels eines zweiten Antriebsmittels bei Erreichen des Abgabebereichs und hierdurch Setzen des Fügeelements in mindestens ein Bauteil, wobei das Schubelement vorzugsweise ein Drehmoment zwischen 3 Nm und 30 Nm, besonders bevorzugt bis zu 15 Nm überträgt. Neben dem Schieben des Fügeelements durch den Schlauch kann das Fügeelement somit über das Schubelement in Rotation versetzt werden. Dieses Verfahren ist daher besonders für Fügeelemente mit einem am Kopf vorgesehenen Eingriffsmittel wie Schrauben oder dergleichen geeignet. In diesem Zusammenhang wird insbesondere auf die obigen Ausführungen zu der bevorzugten Ausgestaltung der Zuführvorrichtung mit Übertragungsmittel am Schubelement verwiesen.

### 4. Kurzzusammenfassung der Zeichnungen

Nachfolgend wird die vorliegende Erfindung unter Bezugnahme auf die Zeichnungen detailliert beschrieben. Gleiche Bezugszeichen in den Zeichnungen bezeichnen dabei gleiche Bauteile und/oder Elemente. Es zeigen:
- Figur 1: eine erste perspektivische Ansicht einer ersten Ausführungsform einer erfindungsgemä-βen Zuführvorrichtung,
- Figur 2: eine zweite perspektivische Ansicht der ersten Ausführungsform einer erfindungsgemäßen Zuführvorrichtung mit halbtransparentem Profilschlauch,
- Figur 3: eine perspektivische Ansicht der Zuführeinrichtung aus Figur 1 ohne Profilschlauch,
- Figur 4: eine perspektivische Teilansicht der Zuführeinrichtung aus Figur 2 ohne Abgabebereich,
- Figur 5: eine perspektivische Ansicht einer Ausführungsform eines Setzwerkzeugs mit einer zweiten Ausführungsform einer erfindungsgemäßen Zuführvorrichtung,
- Figur 6: eine erste perspektivische Ansicht der zweiten Ausführungsform der erfindungsgemäßen Zuführvorrichtung gemäß Figur 5,
- Figur 7: eine zweite perspektivische Ansicht der zweiten Ausführungsform der erfindungsgemäßen Zuführvorrichtung gemäß Figur 5,
- Figur 8: eine perspektivische Ansicht des Aufnahmebereichs der Zuführvorrichtung gemäß Figur 5,
- Figur 9: eine Schnittansicht des Aufnahmebereichs der Zuführvorrichtung gemäß Figur 8,
- Figur 10: eine Seitenansicht des Aufnahmebereichs sowie des Antriebsmittels und des Schubelements gemäß Figur 5,
- Figur 11: eine Schnittansicht des Aufnahmebereichs sowie des Antriebsmittels und des Schubelements gemäß Figur 10,
- Figur 12: eine Teilschnittansicht des Aufnahmebereichs der zweiten Ausführungsform der Zuführvorrichtung in einem Ausgangszustand,
- Figur 13: eine Teilschnittansicht des Aufnahmebereichs der zweiten Ausführungsform der Zuführvorrichtung in einem Beladezustand,
- Figur 14: eine Teilschnittansicht des Aufnahmebereichs der zweiten Ausführungsform der Zuführvorrichtung in einem Beförderungszustand
- Figur 15: eine perspektivische Ansicht einer weiteren Ausführungsform einer erfindungsgemäßen Zuführvorrichtung mit Übertragungsmittel am Schubelement,
- Figur 16: einen schematischen Verfahrensablauf einer Ausführungsform eines Zuführverfahrens und
- Figur 17: einen schematischen Verfahrensablauf einer Ausführungsform eines Setzverfahrens unter Verwendung einer Zuführvorrichtung mit einem Übertragungsmittel am Schubelement.

### 5. Detaillierte Beschreibung der bevorzugten Ausführungsformen

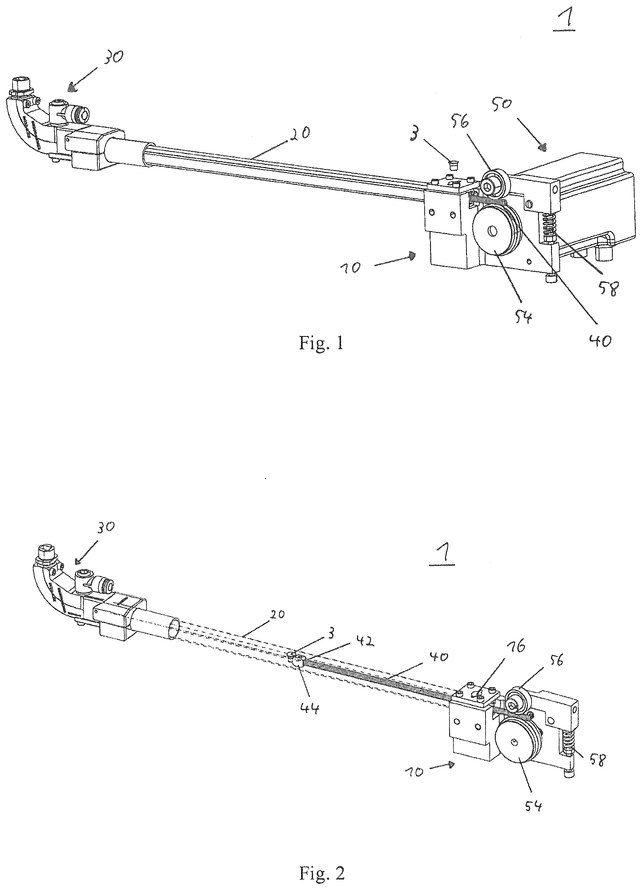

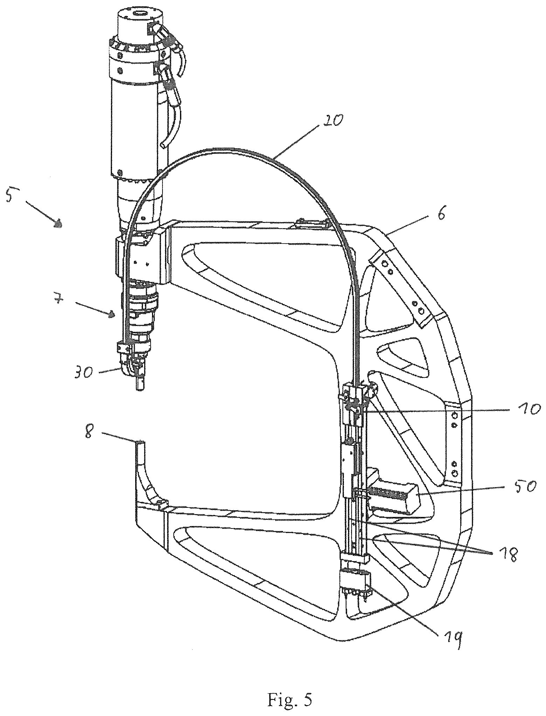

Zur besseren Nachvollziehbarkeit wird unter Bezugnahme auf die Figuren 1 bis 4 eine Ausführungsform der erfindungsgemäßen Zuführvorrichtung 1 nachfolgend anhand ihrer Verwendung erläutert. Vorzugsweise wird die Zuführvorrichtung 1 in Verbindung mit einem Setzwerkzeug 5 verwendet, das einen Setzkopf 7 mit einem Stempel sowie eine gegenüber dem Stempel angeordnete Matrize 8 umfasst. Das Setzwerkzeug 5 ist an einem C-Rahmen 6 als Träger montiert, der robotergeführt bewegbar ist (vgl. auch Figur 5). Weiterhin ist eine Fügeelementquelle vorhanden. Bei den Fügeelementen 3 handelt es sich beispielsweise um Niete.

Die Zuführvorrichtung 1 umfasst einen Aufnahmebereich 10 für mindestens ein Fügeelement 3, einen umfänglich geschlossenen Schlauch 20 aus flexiblem Material, einen Abgabebereich 30 sowie ein flexibles Schubelement 40. Der Schlauch 20 ist an einem ersten Ende 22 mit dem Aufnahmebereich 10 und an einem gegenüberliegenden zweiten Ende 24 mit dem Abgabebereich 30 verbunden.

Bei der Verwendung mit einem Setzwerkzeug ist der Abgabebereich 30 vorzugsweise am oder benachbart zum Setzkopf, insbesondere dem Stempel des Setzkopfs, angeordnet. In der dargestellten Ausführungsform weist der Abgabebereich 30 eine gebogene Form auf, die so dass zwischen einem Eintritts- und einem Austrittsende des Fügeelements 3 in den Abgabebereich 30 ein Winkel von 90° vorhanden ist. Der Aufnahmebereich 10 ist entfernt vom Setzkopf vorgesehen.

Aufgrund dieses Abstands zwischen dem Aufnahmebereich 10 und dem Abgabereich 30 sowie der verschiedenen Positionen, die das Setzwerkzeug im Raum aufgrund beispielsweise der Roboterführung einnehmen kann, weist der Schlauch 20 in der Regel einen krummlinigen Verlauf auf. Dieser umfasst daher eine Vielzahl an Kurven und Bewegungen. Um das Fügeelement 3 daher mit dem Schubelement 40 durch den Schlauch 20 zu dem Abgabebereich 30 zu befördern, muss das Schubelement 40 dem Verlauf des Schlauchs 20 folgen können. Daher ist das Schubelement 40 flexibel ausgeführt. Zudem ist zu beachten, dass eine Länge des Schlauchs 20 beispielsweise mindestens 50 cm, vorzugsweise mindestens 60 cm besonders bevorzugt mindestens 70 cm beträgt, was den Abstand zwischen dem Aufnahmebereich 10 und dem Abgabereich 30 weiter verdeutlicht.

Weiterhin werden in der hier gezeigten Ausgestaltung Niete als Fügeelement 3 verwendet. Bei dieser Art der Fügeelemente 3 greift das Schubelement 40 quer zu einer Längsachse des Fügeelements 3 an diesem an. Um daher ein Verkanten oder Verkippen des Fügeelements 3 in dem Schlauch 20 zu vermeiden, ist der Schlauch 20 vorzugsweise als Profilschlauch ausgebildet.

Entsprechende flexible Profilschläuche sind aus dem Bereich der Druckluftzufuhr von Fügeelementen 3 bekannt. Diese sind umfänglich geschlossen ausgebildet und weisen im inneren eine Querschnittsform auf, die der Querschnittsform des zu befördernden Fügeelements 3 entspricht. Im dargestellten Beispiel ist die Querschnittsform daher T-förmig.

Bei dem Schubelement 40 handelt es sich in der dargestellten Ausführungsform um einen Federstab. Alternativ hierzu ist die Verwendung eines Elastomer-Stabs, eines Gliederstranges, eines Stahlseils, eines Bowdenzugs oder eines drucksteifen Federblechs bevorzugt. Durch die Auswahl des jeweils geeigneten Schubelements 40 kann die Zuführvorrichtung 1 effektiv an den jeweiligen Anwendungsfall angepasst werden, beispielsweise im Hinblick auf den zur Verfügung stehenden Bauraum. Dabei kommt als Schubelement 40 jedes Element infrage, das einen krummlinigen im Verlauf des Schlauchs 20 zwischen dem Aufnahmebereich 10 und dem Abgabebereich 30 folgen kann.

Zu beachten ist allerdings, dass das Schubelement 40 sich bei Druck möglichst nicht oder nur wenig komprimiert, um eine ordnungsgemäße Beförderung des Fügeelements 3 zum Abgabebereich 30 sicherzustellen. In diesem Zusammenhang ist auch die Länge des Schlauchs 20 von mindestens 50 cm zu beachten. Denn das Schubelement 40 muss mindestens diese Länge aufweisen, um das Fügeelement 3 von dem Aufnahmebereich 10 in den Abgabebereich 30 zu befördern.

Um sicherzustellen, dass das Schubelement 40 in Schubrichtung nicht oder nur wenig komprimierbar ist, ist das Schubelement 40 im eingefahrenen Zustand zumindest teilweise auf einer Trommel aufgewickelt oder in einem Gehäuse angeordnet. Die Trommel bzw. das Gehäuse sind mit Bezugszeichen 46 gekennzeichnet.

Weiterhin vorteilhaft auf die Funktionsweise wirkt sich die Querschnitts-Dimensionierung des Schubelements 40 aus. So weist das Schubelement 40 in der dargestellten Ausführungsform eine Querschnittsfläche auf, die zwischen 30 und 80 % der Querschnittsfläche des Schlauchs 20 liegt. Dies gilt insbesondere in Verbindung mit der Verwendung eines Profilschlauchs als Schlauch 20.

Die Querschnittsfläche des Schubelements 40 errechnet sich dabei ausschließlich basierend auf seinem Außendurchmesser bzw. seinen äußeren Abmessungen, unabhängig von seiner tatsächlichen Gestaltung. Hierdurch wird sichergestellt, dass sich das Schubelement 40 nicht im "Zick-Zack" an einer Innenwand des Schlauchs 20 anlegt. Denn dies würde zu einer Abweichung zwischen der Länge des Schlauchs 20 und der Länge des Schubelements 40 im Schlauch 20 führen. Diese Länge ist jedoch wichtig, damit das Fügeelement 3 ordnungsgemäß zum Abgabebereich 30 befördert und dies auch korrekt erfasst wird, was nachfolgend im Rahmen der Verwendung erläutert wird.

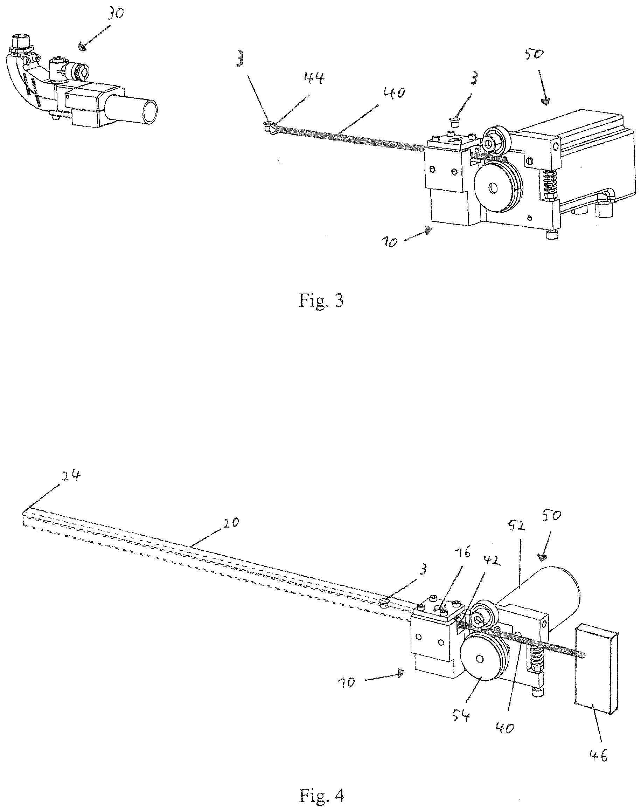

Bei der Verwendung der Zuführvorrichtung 1 werden die Fügeelemente 3 dem Aufnahmebereich 10 von der Fügeelementquelle zugeführt. Dazu weist der Aufnahmebereich 10 eine Zuführöffnung 16 auf. In der dargestellten Ausführungsform der Figuren 1 und 2 befindet sich diese Zuführöffnung 16 in einer Deckelplatte des Aufnahmebereichs 10. Auf diese Weise gelangt das Fügeelement 3 in den Aufnahmebereich 10 und wird vor der ersten Öffnung 12 (vgl. auch Figur 3) positioniert.

Die Beförderung des Fügeelements 3 von dem Aufnahmebereich 10 hin zu dem Abgabebereich 30 erfolgt durch das Schubelement 40. Dazu wird das Schubelement 40 von einer eingefahrenen Position, in der es sich im Aufnahmebereich 10 befindet, in eine ausgefahrene Position bewegt, in der es sich im Abgabebereich 30 befindet. In dem dargestellten Beispiel befindet sich das Schubelement 40 und mit ihm das Fügeelement 3 in dem Schlauch 20. Dabei greift das Schubelement 40 das Fügeelement 3 seitlich an, d.h. aus einer Richtung quer zur Längsachse des Fügeelements 3.

Damit das Fügeelement 3 an dem Schubelement 40 anliegt, sich also auch aufgrund der Schwerkraft möglichst nicht von dem Schubelement 40 entfernt, ist eine Haltevorrichtung 44 an einem vorderen Ende 42 des Schubelements 40 vorgesehen. Bei der Haltevorrichtung 44 handelt es sich insbesondere um ein Formstück oder zwei Halterarmen. Die Ausgestaltung mit der Haltevorrichtung 44 ist insbesondere in Verbindung mit einem Profilschlauch als Schlauch 20 bevorzugt.

In der dargestellten Ausgestaltung ist die Haltevorrichtung 44 ein Formstück, das eine Außenkontur passend zu einer Kontur des Fügeelements 3 sowie passend zu einer Innenkontur des Profilschlauchs als Schlauch 20 aufweist. Zudem ist das Formstück als Haltevorrichtung 44 an einem dem Schubelement 40 zugewandten Ende verjüngt. Die verjüngte Ausgestaltung des Formstücks bzw. der Haltevorrichtung 44 an den dem Schubelement 40 zugewandten Ende bewirkt, dass bei einem Rückhub des Schubelements 40, d. h. bei einer Bewegung von der ausgefahrenen in die eingefahrene Position, das Schubelement 40 möglichst reibungsarm durch den Profilschlauch gezogen werden kann. Dies gilt gerade bei einem krummlinigen im Verlauf des Profilschlauchs.

Die Bewegung des Schubelements 40 durch den Schlauch 20 zwischen einer eingefahrenen Position, in der sich das Schubelement 40 in dem Aufnahmebereich 10 befindet, und einer ausgefahrenen Position, in der sich das Schubelement 40 in dem Abgabebereich 30 befindet, wird über ein entsprechendes Antriebsmittel 50 erreicht. Dazu umfasst das Antriebsmittel 50 in der dargestellten Ausführungsform einen elektrischen Aktor 52, beispielsweise einen elektrischen Motor. Gerade die Verwendung eines elektrischen Aktors 52 ist besonders bevorzugt, da auf diese Weise die Zuführvorrichtung 1 ohne jegliche Pneumatik-Komponenten auskommt.

Alternativ kann bei der Wahl des Antriebsmittels 50 ein an dem Setzwerkzeug 5 oder dem Einsatzort zur Verfügung stehendes Betriebsmittel berücksichtigt werden. So kann alternativ zu dem elektrischen Aktor 52 auf ein bereits bestehendes Versorgungsnetz mit Druckluft oder dergleichen zugegriffen und als Aktor ein pneumatischer Aktor oder ein hydraulischer Aktor für das Antriebsmittel 50 gewählt werden.

Das Antriebsmittel 50 umfasst weiterhin zwei Räder 54, 56. Zwischen den Rädern 54, 56 ist das Schubelement 40 geführt. Ein erstes Rad 54 ist dabei über den Aktor 52 angetrieben. Mindestens eines der zwei Räder 54, 56 weist eine Rändelung, eine Elastomer-Beschichtung oder einen Elastomer-Ring auf. Zudem ist das zweite Rad 56 in Richtung des ersten Rads 54 über eine Feder 58 federvorgespannt angeordnet.

Gerade die Außenkontur und der Werkstoff des ersten Rads 54, d. h. des Antriebsrads, aber auch die vorgespannte Anordnung sorgen dafür, dass im Kontaktbereich zwischen den Rädern 54, 56 und dem Schubelement 40 eine möglichst hohe Reibung erzeugt wird. Dadurch wird eine Relativbewegung zwischen den Rädern 54, 56 und dem Schubelement 40 vermieden. Dies wirkt sich positiv auf die ordnungsgemäße Funktion der Zufuhrvorrichtung 1 aus.

Um die Zufuhr des Fügeelements 3 zu steuern und/oder zu überwachen, umfasst die Zuführvorrichtung 1 mindestens einen der folgenden Sensoren: einen Wegsensor, einen Kraftsensor, einen Drehmomentsensor und/oder einen Geschwindigkeitssensor.

Gerade bei der bevorzugten weggesteuerten Zufuhr des Fügeelements 3 von dem Aufnahmebereich 10 zu dem Abgabebereich 30 darf das Schubelement 40 möglichst nicht gestaucht werden. Dies wird beispielsweise darüber erreicht, dass als Schubelement 40 ein auf Block gewickelter Federstab verwendet wird, wie eingangs erläutert.

Der Vollständigkeit halber wird in diesem Zusammenhang darauf hingewiesen, dass auch bei einer kraftgesteuerten Variante eine Stauchung des Schubelements 40 zu Problemen führen würde. Dies ist darin begründet, dass ein Kraftanstieg stark abgeschwächt oder verzögert am Antriebsmittel 50 und einem dort verwendeten Kraftsensor ankäme.

Um die mit einer Stauchung des Schubelements 40 einhergehenden Nachteile zu vermeiden, kann alternativ oder zusätzlich ein Positionssensor verwendet werden. Dieser erkennt, ob das Fügeelement 3 die gewünschte Position im oder in Zuführrichtung des Fügeelements 3 hinter dem Abgabebereich 30 erreicht hat.

Bei der beispielhaften Wegsteuerung detektiert der Wegsensor nach jedem Rückhub, d.h. nach jeder Bewegung von der ausgefahrenen Position in die eingefahrene Position, dass das Schubelement 40 wieder in der eingefahrenen Position, also hinter der ersten Öffnung 12 in dem Aufnahmebereich 10 angeordnet ist. Hier wird der Weg also vor jedem neuen Zuführvorgang genullt.

Die zurückzulegende Strecke beim Vorhub, d.h. bei der Bewegung von der eingefahrenen in die ausgefahrene Position, wird beispielsweise über die Umdrehungen einer Motorwelle des Antriebsmittels 50 definiert. Eine Umrechnung der Umdrehungen der Motorwelle in den zurückgelegten Weg des Schubelements 40 erfolgt über den Wirkdurchmesser des Antriebsrads, in dem dargestellten Beispiel somit des ersten Rads 52.

Alternativ wird ein Drehmoment des Motors und die Reibung des Antriebsrads bzw. des ersten Rads 52 so gewählt, dass der Motor stehen bleibt, wenn das Fügeelement 3 im oder durch den Abgabebereich 30 an der gewünschten Position angekommen ist und das Schubelement 40 nicht weitergeschoben werden kann. Dieser Zustand kann beispielsweise auch mit einem Geschwindigkeitssensor erfasst werden, da die Ist-Geschwindigkeit des Schubelements 40 in diesem Fall null ist.

Sobald das Fügeelement 3 den Abgabebereich 30 erreicht oder passiert, wird es in dem vorliegenden Beispiel an den Setzkopf abgegeben. In anderen Beispielen kann die Zuführvorrichtung 1 allgemein dazu verwendet werden, Fügeelemente 3 von einer ersten Position zu einer entfernten zweiten Position zu befördern.

Ein Vorteil dieser Zuführvorrichtung 1 ist, dass keine Pneumatik-Komponenten benötigt werden, um ein Fügeelement von dieser ersten Position, d. h. dem Aufnahmebereich 10, zu einer zweiten Position zu bewegen, d. h. dem Abgabebereich 30. Dies wirkt sich vorteilhaft im Hinblick auf die entstehenden Kosten sowie die Nachhaltigkeit aus. Dabei stellt gerade die Verwendung des flexiblen Schubelements 40 sicher, dass das Fügeelement 3 in jeder Raumlage, d. h. auch gegen die Schwerkraft, verlässlich von dem Aufnahmebereich 10 zu dem Abgabebereich 30 befördert wird.

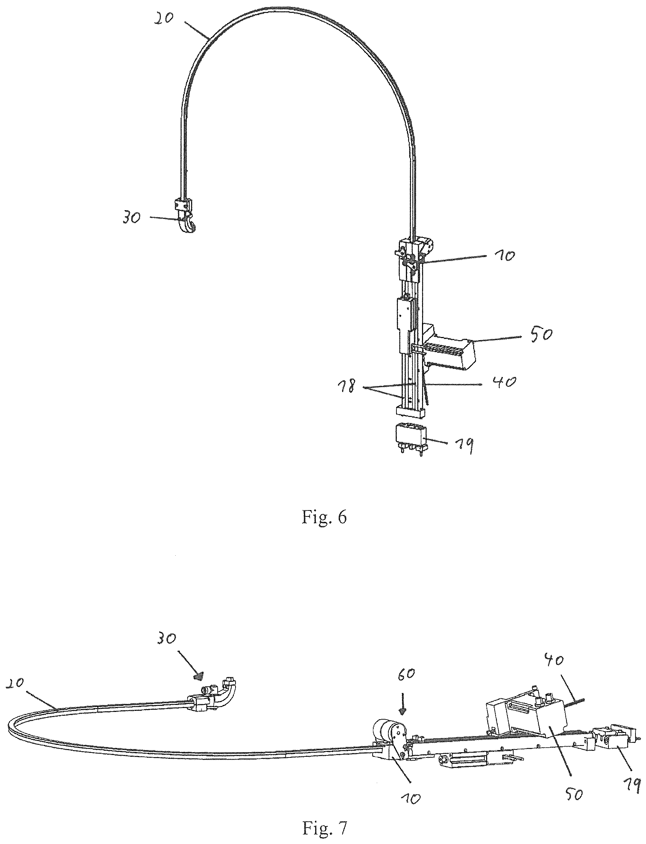

Nun bezugnehmend auf Figur 5 ist ein Setzwerkzeug 5 mit einer zweiten Ausführungsform der Zuführvorrichtung 1 gezeigt. Diese unterscheidet sich von der ersten Ausführungsform im Wesentlichen durch die Ausgestaltung des Aufnahmebereichs 10, was später unter Bezugnahme auf die Figuren 6 bis 14 erläutert wird.

Zunächst wieder auf die Ausgestaltung des Setzwerkzeugs 5 bezugnehmend weist dieses einen Setzkopf 7 und eine Matrize 8 auf, die beide an dem C-Rahmen 6 als Träger montiert sind. Der C-Rahmen 6 ist beispielsweise robotergeführt bewegbar.

An dem C-Rahmen 6 ist der Aufnahmebereich 10 der Zuführvorrichtung 1 montiert. In dem dargestellten Beispiel erfolgt dies an dem die beiden horizontalen Vorsprünge verbindenden senkrechten Bereich der C-Form. Wie vorher bereits erläutert, ist der Aufnahmebereich 10 über den Schlauch 20 mit dem Abgabebereich 30 verbunden. Der Abgabebereich 30 ist, wie dargestellt, am Setzkopf 7 angeordnet.

Im Unterscheid zu der vorherigen Ausgestaltung werden dem Aufnahmebereich 10 die Fügeelemente 3 nicht einzeln, sondern mittels zweier Staustrecken 18 zugeführt. Die Staustrecken 18 können einem separaten Gehäuse zugeordnet sein, das mit dem Aufnahmebereich 10 verbunden ist, oder integraler Bestandteil des Aufnahmebereichs 10 sein. Im Ergebnis werden die Fügeelemente 3 dem Aufnahmebereich 10 somit nicht einzeln zugeführt, sondern in den Staustrecken 18 ist eine Vielzahl von Fügeelementen 3 vorhanden.

Das Antriebsmittel 50 ist daher benachbart zu einem Gehäuse der Staustrecken 18 angeordnet. Die Staustrecken 18 sind mit einem passenden Verschluss versehen, damit keine Fügeelemente 3 aus der Staustrecke fallen können. Zudem ist die Anwesenheit einer Docking-Station 19 gezeigt.

Die Figuren 6 und 7 zeigen die Anordnung gemäß Figur 5 ohne den C-Rahmen 6, den Setzkopf 7 und die Matrize 8, um das Verständnis zu verbessern. Insbesondere in Figur 7 ist erkennbar, dass an dem Aufnahmebereich eine Spannvorrichtung 60 vorgesehen ist, um die in den Staustrecken 18 enthaltenen Fügeelemente 3 in Anlage aneinander in der Staustrecke 18 zu halten.

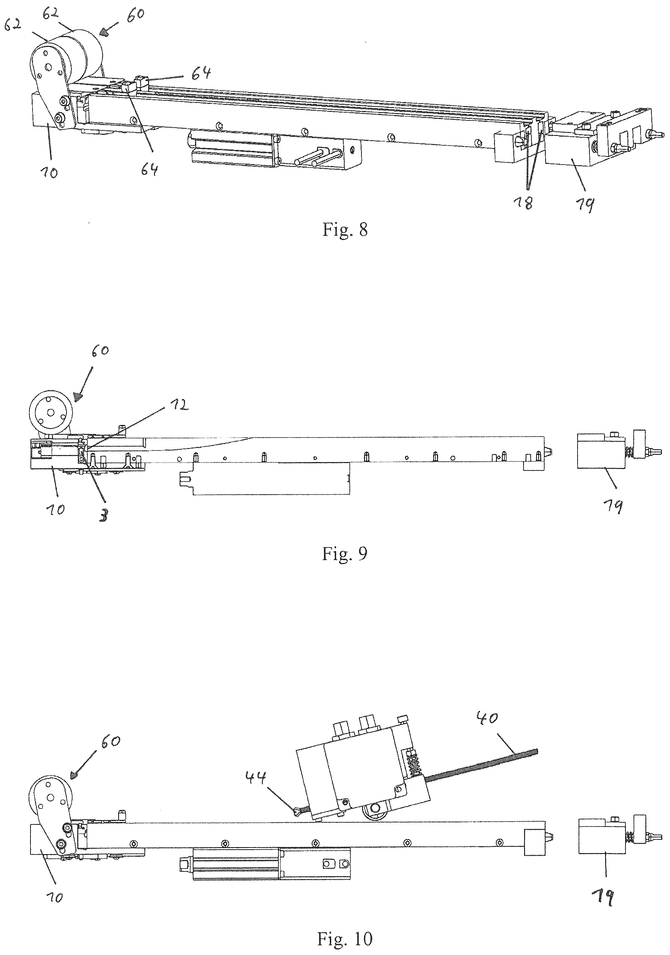

Wie gerade aus Figur 8 ersichtlich ist, sind die Staustrecken 18 auf unterschiedliche Fügeelemente 3 ausgelegt. So ist die linke oder vordere Staustrecke 18 auf Fügeelemente 3 mit einem kürzeren Schaft ausgelegt, während die rechte oder hintere Staustrecke 18 auf Fügeelemente 3 mit einem längeren Schaft ausgelegt ist. Selbstverständlich kann die Anordnung der Staustrecken 18 auch umgekehrt erfolgen oder in beiden Staustrecken 18 können Fügeelemente 3 vom gleichen Typ enthalten sein.

Die Spannvorrichtung 60 umfasst zwei Spannrollen oder Rollen 62. Darauf aufgewickelt ist ein flexibles Element, mit dem über entsprechende Spannstücke 64 eine Spannung auf die in der Staustrecke 18 enthaltenen Fügeelemente 3 in Richtung des Aufnahmebereichs 10 ausübbar ist.

Zur Verdeutlichung zeigt Figur 9 eine Schnittansicht der Darstellung aus Figur 8. Hier ist erkennbar, dass zwischen den Staustrecken 18 ein Kanal vorgesehen ist, in den im Betrieb das Schubelement 40 eingeführt wird, um ein vor der ersten Öffnung 12 positioniertes Fügeelement 3 in den Profilschlauch 20 und zu dem Abgabebereich 30 zu befördern.

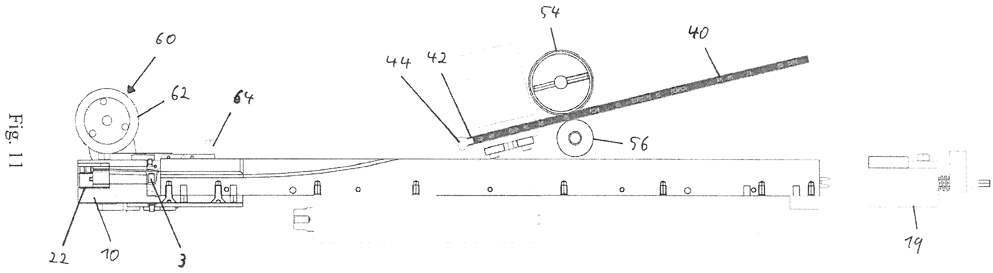

Die Figuren 10 und 11 zeigen die Ausgestaltung gemäß den Figuren 8 und 9 zusammen mit dem Antriebsmittel 50 und dem Schubelement 40 in Seitenansicht (Figur 10) und im Schnitt (Figur 11). Im Betrieb bewegt das Antriebsmittel 50 das Schubelement 40 mit der Haltevorrichtung 44 voraus in den Kanal und in Anlage mit dem Fügeelement 3 benachbart zur ersten Öffnung 12 im Aufnahmebereich 10. Der Verlauf des Kanals wird dabei gerade aus Figur 11 deutlich.

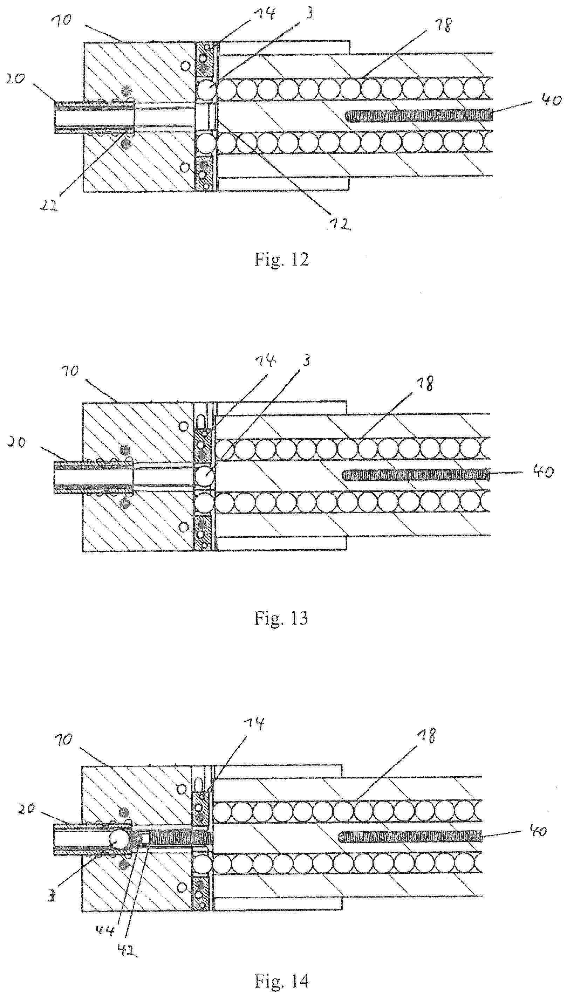

Nun Bezug nehmend auf die Figuren 12 bis 14 wird eine Schnittansicht des alternativen Aufnahmebereichs 10 der Zufuhrvorrichtung 1 gezeigt. Hier wird ersichtlich, dass der Aufnahmebereich 10 über ein Vereinzelungsmittel 14 verfügt. Auf diese Weise wird sichergestellt, dass dem Abgabebereich 30 immer nur ein Fügeelement 3 zugeführt wird. Wie oben erläutert, wird das Schubelement 40 über den Kanal in den Aufnahmebereich 10 hineingeführt und befindet sich im eingefahrenen Zustand in bekannter Weise in oder hinter der ersten Öffnung 12. Figur 12 zeigt den entsprechenden Ausgangszustand.

Soll nun ein Fügeelement 3 von dem Aufnahmebereich 10 zu dem Abgabebereich 30 befördert werden, wird zunächst das Vereinzelungsmittel 14 betätigt. Hierbei handelt es sich um ein mechanisches Mittel, wie beispielsweise einen mechanischen Schieber, der über einen Aktor betätigt wird. Das Vereinzelungsmittel 14 bewegt das Fügeelement 3 vor die erste Öffnung 12 und somit vor das Schubelement 40. Dieser Zustand ist in Figur 13 gezeigt. In Abhängigkeit von der Orientierung des Aufnahmebereichs 10 im Raum kann die entsprechende Positionierung auch mit Hilfe der Schwerkraft erfolgen.

Nun wird das Schubelement 40 wie oben beschrieben betätigt, sodass das Fügeelement 3 in den Schlauch 20, insbesondere den Profilschlauch, durch den Schlauch 20 und bis zum Abgabebereich 30 bewegt wird. Der Beginn dieses Zustands ist in Figur 14 dargestellt. Zudem wird hierzu auf die obigen Ausführungen im Hinblick auf die Funktionsweise verwiesen.

Das Vereinzelungsmittel 14 stellt somit sicher, dass immer nur ein einzelnes Fügeelement 3 von dem Aufnahmebereich 10 durch den Schlauch 20 und zu dem Abgabebereich 30 gefördert wird.

Nachdem das Fügeelement 3 im Abgabebereich 30 positioniert und/oder abgegeben wurde, wird das Schubelement 40 durch den Schlauch 20 von der ausgefahrenen Position in die eingefahrene Position zurückbewegt. Dabei ist die verjüngte Ausgestaltung des Formstücks an dem dem Schubelement 40 zugewandten Ende vorteilhaft, denn diese bewirkt, dass bei dem Rückhub des Schubelements 40 das Schubelement 40 möglichst reibungsarm durch den Schlauch 20 gezogen werden kann, gerade bei einem krummlinigen Verlauf des Schlauchs 20. Ohne die verjüngte Ausgestaltung könnte sich, beispielsweise bei Verwendung eines Federstabs als Schubelement 40, das Schubelement 40 zunächst längen und dann plötzlich zurückschnellen, sobald die Kraft erreicht wird, die erforderlich ist, um die Klemmstelle zu überwinden.

Sobald sich das Schubelement 40 wieder in der eingefahrenen Position befindet, kann der oben skizierte Ablauf wiederholt werden und ein neues oder weiteres Fügeelement 3 dem Abgabereich zugeführt werden. Bezogen auf die Ausgestaltung mit der Staustrecke 18 wird somit das nachgerückte Fügeelement 3 vereinzelt und vor der Öffnung 12 positioniert, damit es von dem Schubelement 40 dem Abgabebereich 30 zugeführt werden kann.

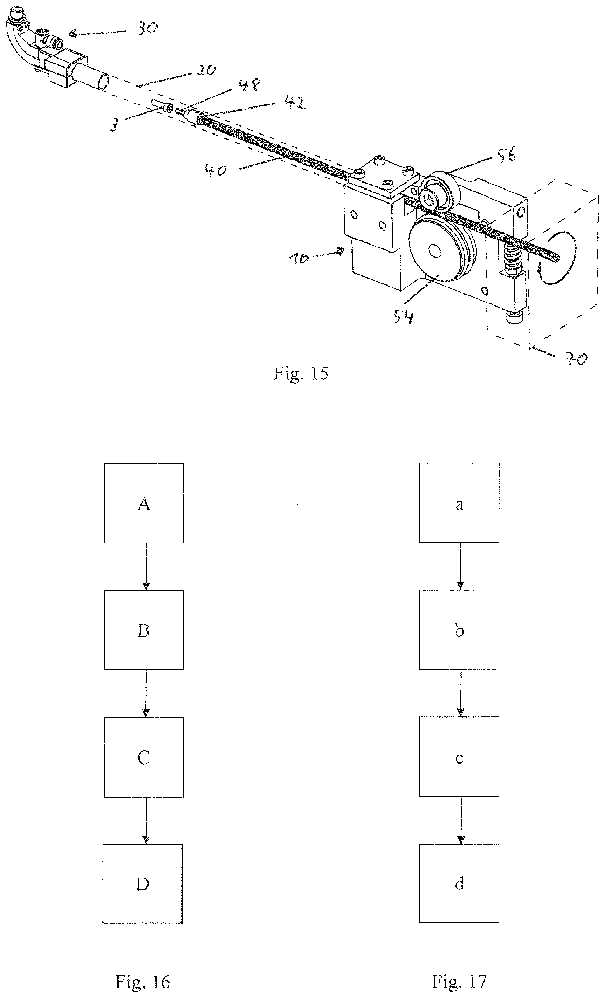

Nun bezugnehmend auf Figur 15 wird eine alternative Ausgestaltung der Zuführvorrichtung 1 diskutiert. Diese wird insbesondere in Verbindung mit einer Schraube oder dergleichen als Fügeelement verwendet.

In dieser Ausgestaltung der Zuführvorrichtung 1 weist das Schubelement 40 benachbart zu dem vorderen Ende 42 ein Übertragungsmittel 48 auf. Dieses ist mit einem Kopf des Fügeelements 3, beispielsweise der Schraube, in Eingriff bringbar. Schrauben weisen an ihrem Kopfende eine innere und/oder äußere Form auf, die den Eingriff eines Werkzeugs gestattet, um das als Schraube ausgebildete Fügeelement 3 zu drehen. Um mit dieser Form in Eingriff zu gelangen, weist das Schubelement 40 das entsprechend gestaltete Übertragungsmittel 48 auf. Im dargestellten Beispiel handelt es sich bei dem Übertragungsmittel um einen Außensechskant, so dass die Schraube einen Innensechskant am Kopf aufweist.

Im Unterschied zu dem vorherigen Beispiel mit dem Niet als Fügeelement 3 greift das Schubelement 40 das als Schraube ausgestaltete Fügeelement 3 somit nicht quer zur Längsachse des Fügeelements 3 an, sondern entlang der Längsachse des Fügeelements 3. Die Verwendung eines Profilschlauchs als Schlauch 20 ist somit nicht möglich.

Zudem ist das Schubelement 40, das vorzugsweise als eine flexible Welle ausgebildet ist, mit einem zweiten Antriebsmittel 70 versehen, das das Schubelement 40 in Rotation versetzt. Die Rotation des Schubelements 40 lässt sich aufgrund des Übertragungsmittels 48 auf das Fügeelement 3 übertragen, so dass die Schraube als Fügeelement 3 in mindestens ein Bauteil, vorzugsweise in mindestens zwei Bauteile, geschraubt oder gesetzt werden kann.

Während der Verwendung wird die Schraube als Fügeelement 3 somit in der oben beschriebenen Weise von dem Aufnahmebereich 10 durch den Schlauch 20 zu dem Abgabebereich 30 geschoben. Vorzugsweise ist der Abgabebereich 30 dabei nicht an einem Setzkopf eines Setzwerkzeugs angeordnet, sondern endet an einem Bauteil, liegt also beispielsweise auf diesem auf. Nachdem das Schubelement 40 das Fügeelement 3 durch den Schlauch 20 geschoben hat, liegt somit eine Spitze des Fügeelements 3 an dem ersten Bauteil an. Aufgrund der vorzugsweise starren Ausgestaltung des Abgabebereichs 30 ist das Fügeelement 3 zudem in radialer Richtung sicher positioniert.

Wird nun das zweite Antriebsmittel 70 betätigt, dann versetzt dieses das Schubelement 40 in Rotation, die über das Übertragungsmittel 48 auf das Fügeelement 3 übertragen wird. Somit kann das Fügeelement 3 in mindestens das erste Bauteil gesetzt werden. Vorzugsweise überträgt das Schubelement 40 dabei ein Drehmoment zwischen 3 Nm und 30 Nm, vorzugsweise bis 15 Nm.

Bezugnehmend auf Figur 16 wird eine Ausführungsform eines erfindungsgemäßen Zuführverfahrens unter Verwendung einer Ausführungsform der erfindungsgemäßen Zuführvorrichtung 1 erläutert. In einem ersten Schritt A erfolgt ein Zuführen des Fügeelements 3 zu dem Aufnahmebereich 10 der Zuführvorrichtung 1. Zudem wird das Fügeelement 3 vor der ersten Öffnung im Aufnahmebereich 10 positioniert. Dies erfolgt in Schritt B. Am Ende dieses Schritts ist das Fügeelement 3 vor dem flexiblen Schubelement 40 angeordnet.

Nun wird das Schubelement 40 in Schritt C von einem eingefahrenen Zustand in einen ausgefahrenen Zustand bewegt. Dies erfolgt über das Antriebsmittel 50. Dadurch wird das vor dem Schubelement 40 positionierte Fügeelement 3 in Richtung des Abgabebereichs 30 durch den Schlauch 20 bewegt.

Abschließend erfolgt in Schritt D das Abgeben des Fügeelements 3 bei Erreichen des Abgabebereichs 30, d.h. der gewünschten Position im Abgabebereich 30 oder in Zuführrichtung des Fügeelements 3 hinter dem Abgabereich 30, sowie das Zurückbewegen des flexiblen Schubelements 40 von der ausgefahrenen in die eingefahrene Position.

Anschließend können sich die obigen Verfahrensschritte A bis D wiederholen, wenn dem Aufnahmebereich 10 bereits vereinzelte Fügeelemente 3 zugeführt werden. Sofern dem Aufnahmebereich 10 bereits eine Mehrzahl an Fügeelementen 3 beispielsweise aufgrund einer Staustrecke 18 zur Verfügung steht, ist es bevorzugt, die Schritte B bis D zu wiederholen.

Abschließend bezugnehmend auf Figur 17 wird eine Ausführungsform eines Setzverfahren unter Verwendung der Zuführvorrichtung 1 mit einem am Schubelement 40 vorgesehenen Übertragungsmittel 48 erläutert. Hier erfolgt in einem ersten Schritt a ein Zuführen des Fügeelements 3 zu dem Aufnahmebereich 10 der Zuführvorrichtung 1. Diesem schließt sich im nachfolgenden Schritt b ein Positionieren des Fügeelements 3 vor der ersten Öffnung 12 im Aufnahmebereich 10 an, wodurch das Fügeelement 3 vor einem flexiblen Schubelement 40 angeordnet ist. Im Unterschied zu der vorherigen Ausführungsform ist das Fügeelement 3 dabei so positioniert, dass das Schubelement 40 am Fügeelement 3 entlang der Längsachse des Fügeelements 3 angreift, vorzugsweise am Kopf des Fügeelements 3.

In Schritt c erfolgt nun ein Bewegen des Schubelements 40 von einem eingefahrenen Zustand in einen ausgefahrenen Zustand, wodurch das vor dem Schubelement 40 positionierte Fügeelement 3 in Richtung des Abgabebereichs 30 durch den Schlauch 20 bewegt wird

Nun wird in Schritt d ein Drehmoment auf das Fügeelement 3 über das Übertragungsmittel 48 am vorderen Ende 42 des Schubelements 40 mittels eines zweiten Antriebsmittels 70 bei Erreichen des Abgabebereichs 30 aufgebracht. Hierdurch erfolgt ein Setzen des Fügeelements 3 in mindestens ein Bauteil, wobei das Schubelement 40 vorzugsweise ein Drehmoment zwischen 3 Nm und 30 Nm, besonders bevorzugt bis zu 15 Nm überträgt.

### 6. Bezugszeichenliste

- 1: Zuführvorrichtung
- 3: Fügeelement
- 5: Setzwerkzeug
- 6: C-Rahmen
- 7: Setzkopf
- 8: Matrize
- 10: Aufnahmebereich
- 12: erste Öffnung im Aufnahmebereich 10
- 14: Vereinzelungsmittel
- 16: Zuführöffnung
- 18: Staustrecke
- 19: Docking-Station

- 20: Schlauch
- 22: erstes Ende des Schlauchs
- 24: zweites Ende des Schlauchs

- 30: Abgabebereich

- 40: Schubelement
- 42: vorderes Ende
- 44: Haltevorrichtung
- 46: Gehäuse für das Schubelement 40
- 48: Übertragungsmittel

- 50: Antriebmittel
- 52: Aktuator
- 54: erstes Rad
- 56: zweites Rad
- 58: Feder

- 60: Spannvorrichtung
- 62: Rolle
- 64: Spannstück

- 70: zweites Antriebsmittel

## Patentansprüche

1. Eine Zuführvorrichtung (1) für Fügeelemente (3), umfassend:
a. einen Aufnahmebereich (10) für mindestens ein Fügeelement (3), in dem ein Fügeelement (3) aufnehmbar und vor einer ersten Öffnung (12) positionierbar ist,
b. einen umfänglich geschlossenen Schlauch (20) aus einem flexiblen Material, der an einem ersten Ende (22) mit dem Aufnahmebereich (10) und an einem gegenüberliegenden zweiten Ende (24) mit einem Abgabebereich (30) verbunden ist,
**gekennzeichnet durch**
c. ein flexibles Schubelement (40), das mit einem Antriebsmittel (50) durch den Schlauch (20) zwischen einer eingefahrenen Position, in der sich ein vorderes Ende (42) des Schubelements (40) im Aufnahmebereich (10) befindet, und einer ausgefahrenen Position, in der sich das vordere Ende (42) des Schubelements (40) im Abgabebereich (30) befindet, hin und her bewegbar ist, so dass das vor der ersten Öffnung (12) positionierte Fügeelement (3) mit dem Schubelement (40) aus dem Aufnahmebereich (10) durch den Schlauch (20) in den Abgabebereich (30) schiebbar ist.

2. Die Zuführvorrichtung (1) gemäß Patentanspruch 1, wobei der Aufnahmebereich (10) weiterhin ein Vereinzelungsmittel (14) umfasst, um ein Fügeelement (3) von einer Mehrzahl an Fügeelementen (3) zu trennen und vor der ersten Öffnung (12) zu positionieren, vorzugsweise ein mechanisches Mittel.

3. Die Zuführvorrichtung (1) gemäß einem der vorhergehenden Patentansprüche, wobei das Schubelement (40) eines der folgenden umfasst: einen Federstab, vorzugsweise einen auf Block gewickelten Federstab, einen Elastomer-Stab, einen Gliederstrang, ein Stahlseil, einen Bowdenzug oder ein drucksteifes Federblech.

4. Die Zuführvorrichtung (1) gemäß einem der vorhergehenden Patentansprüche, wobei der Schlauch (20) ein Profilschlauch ist und das Schubelement (40) eine Haltevorrichtung (44) für das Fügeelement (3) benachbart zu dem vorderen Ende (42) des Schubelements (40) umfasst, insbesondere ein Formstück oder zwei Haltearme.

5. Die Zuführvorrichtung (1) gemäß Patentanspruch 4, wobei die Haltevorrichtung (44) ein Formstück umfasst, das
a. eine Außenkontur aufweist, die passend zu einer Kontur des Fügeelements (3) und/oder zu einer Innenkontur des Profilschlauchs (20) ausgestaltet ist, und/oder
b. sich an einem dem Schubelement (40) zugewandten Ende verjüngt.

6. Die Zuführvorrichtung (1) gemäß einem der Patentansprüche 1 bis 3, wobei das Schubelement (40) benachbart zu dem vorderen Ende (42) ein Übertragungsmittel (48) aufweist, das mit einem Kopf des Fügeelements (3) in Eingriff bringbar ist, sodass eine Rotation des Schubelements (40) auf das Fügeelement (3) übertragbar ist.

7. Die Zuführvorrichtung (1) gemäß einem der vorhergehenden Patentansprüche, wobei das Schubelement (40) im eingefahrenen Zustand zumindest teilweise auf einer Trommel aufgewickelt oder in einem Gehäuse angeordnet ist.

8. Die Zuführvorrichtung (1) gemäß einem der vorhergehenden Patentansprüche, wobei das Schubelement (40) eine Querschnittsfläche aufweist, die zwischen 30 und 80 % der Querschnittsfläche des Schlauchs (20), vorzugsweise eines Profilschlauchs, liegt.

9. Die Zuführvorrichtung (1) gemäß einem der vorhergehenden Patentansprüche, wobei das Antriebsmittel (50) einen elektrischen, pneumatischen oder hydraulischen Aktor (52) umfasst.

10. Die Zuführvorrichtung (1) gemäß einem der vorhergehenden Patentansprüche, wobei das Antriebsmittel (50) weiterhin zwei Räder (54, 56) umfasst, zwischen denen das Schubelement (40) geführt ist und von denen mindestens eines angetrieben ist.

11. Die Zuführvorrichtung (1) gemäß Patentanspruch 10, wobei
a. mindestens eines der zwei Räder (54, 56) eine Rändelung, Elastomer-Beschichtung oder Elastomer-Ring aufweist, vorzugsweise beide Räder (54, 56), und/oder
b. ein Rad (56) ist in Richtung des anderen Rades (54) vorgespannt angeordnet, insbesondere federvorgespannt.

12. Die Zuführvorrichtung (1) gemäß einem der Patentansprüche 10 oder 11, die weiterhin mindestens einen der folgenden Sensoren umfasst: einen Wegsensor, einen Kraftsensor, einen Drehmomentsensor und/oder einen Geschwindigkeitssensor.

13. Die Zuführvorrichtung (1) gemäß einem der vorhergehenden Patentansprüche, wobei eine Länge des Schlauchs (20) mindestens 50 cm, vorzugsweise mindestens 60 cm und besonders bevorzugt mindestens 70 cm beträgt.

14. Ein Setzwerkzeug (5) zum Setzen von Fügeelement (3), wobei das Setzwerkzeug (5) eine Zuführvorrichtung (1) gemäß einem der vorhergehenden Patentansprüche umfasst.

15. Das Setzwerkzeug (5) gemäß Patentanspruch 14, wobei der Abgabebereich (30) benachbart zu einem Setzkopf (7) des Setzwerkzeugs (5) und der Aufnahmebereich (10) entfernt von dem Setzkopf (7) angeordnet sind, so dass das Fügeelement (3) durch den Abgabebereich (30) an das Setzwerkzeug (5), insbesondere an den Setzkopf (7) des Setzwerkzeugs (5), abgebbar ist.

16. Ein Zuführverfahren unter Verwendung der Zuführvorrichtung (1) gemäß einem der Patentansprüche 1 bis 13, umfassend die Schritte:
a. Zuführen (Schritt A) eines Fügeelements (3) zu dem Aufnahmebereich (10) der Zuführvorrichtung (1),
b. Positionieren (Schritt B) des Fügeelements (3) vor der ersten Öffnung (12) im Aufnahmebereich (10), wodurch das Fügeelement (3) vor einem flexiblen Schubelement (40) angeordnet ist,
c. Bewegen (Schritt C) des Schubelements (40) von einem eingefahrenen Zustand in einen ausgefahrenen Zustand, wodurch das vor dem Schubelement (40) positionierte Fügeelement (3) in Richtung des Abgabebereichs (30) durch den Schlauch (20), vorzugsweise durch einen Profilschlauch, bewegt wird,
d. Abgeben (Schritt D) des Fügeelements (3) bei Erreichen des Abgabebereichs und Zurückbewegen des flexiblen Schubelements (40) von der ausgefahrenen in die eingefahrene Position.

17. Ein Setzverfahren unter Verwendung der Zuführvorrichtung (1) gemäß einem der Patentansprüche 1 bis 13 in Verbindung mit Patentanspruch 6, umfassend die Schritte:
a. Zuführen (Schritt a) eines Fügeelements (3) zu dem Aufnahmebereich (10) der Zuführvorrichtung (1),
b. Positionieren (Schritt b) des Fügeelements (3) vor der ersten Öffnung (12) im Aufnahmebereich (10), wodurch das Fügeelement (3) vor einem flexiblen Schubelement (40) angeordnet ist,
c. Bewegen (Schritt c) des Schubelements (40) von einem eingefahrenen Zustand in einen ausgefahrenen Zustand, wodurch das vor dem Schubelement (40) positionierte Fügeelement (3) in Richtung des Abgabebereichs (30) durch den Schlauch (20) bewegt wird,
d. Aufbringen (Schritt d) eines Drehmoments auf das Fügeelement (3) über das Übertragungsmittel (48) am vorderen Ende (42) des Schubelements (40) mittels eines zweiten Antriebsmittels (70) bei Erreichen des Abgabebereichs (30) und hierdurch Setzen des Fügeelements (3) in mindestens ein Bauteil, wobei das Schubelement (40) vorzugsweise ein Drehmoment zwischen 3 Nm und 30 Nm, besonders bevorzugt bis zu 15 Nm überträgt.

## Claims

1. A supply device (1) for joining elements (3) comprising:
a. a receiving portion (10) for at least one joining element (3), in which a joining element (3) is receivable and positionable in front of a first opening (12),
b. a circumferentially closed hose (20) of a flexible material which on a first end (22) is connected with the receiving portion (10) and on an opposite, second end (24) with a discharge portion (30), **characterized by**
c. a flexible thrust element (40) which is movable back and forth by means of a drive means (50) through the hose (20) between a retracted position in which a front end (42) of the thrust element (40) is located in the receiving portion (10) and an extended position in which the front end (42) of the thrust element (40) is located in the discharge portion (30), so that the joining element (3) which is positioned in front of the first opening (12) is pushable with the thrust element (40) out of the receiving portion (10) through the hose (20) into the discharge portion (30).

2. The supply device (1) according to claim 1, wherein the receiving portion (10) furthermore comprises a singulation means (14) in order to separate a joining element (3) from a plurality of joining elements (3) and to position it in front of the first opening (12), preferably a mechanical means.

3. The supply device (1) according to one of the preceding claims, wherein the thrust element (40) comprises one of the following: a spring rod, preferably a spring rod wound on block, an elastomer rod, an element string, a steel rope, a Bowden cable or a spring sheet that is rigid in compression.

4. The supply device (1) according to one of the preceding claims, wherein the hose (20) is a profile hose and the thrust element (40) comprises a retaining device (44) for the joining element (3) adjacent to the front end (42) of the thrust element (40), in particular a form piece or two retaining arms.

5. The supply device (1) according to claim 4, wherein the retaining device (44) comprises a form piece which
a. has an outer contour that is configured so as to match a contour of the joining element (3) and/or an inner contour of the profile hose (20), and/or
b. tapers at an end which faces the thrust element (40).

6. The supply device (1) according to one of the claims 1 to 3, wherein the thrust element (40) comprises a transmission means (48) adjacent to the front end (42) which can be engaged with a head of the joining element (3) so that a rotation of the thrust element (40) can be transferred onto the joining element (3).

7. The supply device (1) according to one of the preceding claims, wherein when in the retracted state, the thrust element (40) is at least partly wound on a drum or arranged in a housing.

8. The supply device (1) according to one of the preceding claims, wherein the thrust element (40) has a cross-sectional area between 30% and 80% of the cross-sectional area of the hose (20), preferably a profile hose.

9. The supply device (1) according to one of the preceding claims, wherein the drive means (50) comprises an electric, pneumatic or hydraulic actuator (52).

10. The supply device (1) according to one of the preceding claims, wherein the drive means (50) furthermore comprises two wheels (54, 56), between which the thrust element (40) is guided and of which at least one is driven.

11. The supply device (1) according to claim 10, wherein
a. at least one of the two wheels (54, 56), preferably both wheels (54, 56), has/have a knurling, an elastomer coating or an elastomer ring, and/or
b. one wheel (56) is arranged in a preloaded manner, in particular spring-pretensioned, in the direction of the other wheel (54).

12. The supply device (1) according to one of the claims 10 or 11, furthermore comprising at least one of the following sensors: a path sensor, a force sensor, a torque sensor and/or a speed sensor.

13. The supply device (1) according to one of the preceding claims, wherein a length of the hose (20) is at least 50 cm, preferably at least 60 cm and particularly preferred at least 70 cm.

14. A setting tool (5) for setting joining elements (3), wherein the setting tool (5) comprises a supply device (1) according to one of the preceding claims.

15. The setting tool (5) according to claim 14, wherein the discharge portion (30) is arranged adjacent to a setting head (7) of the setting tool (5) and the receiving portion (10) is arranged remote from the setting head (7) so that the joining element (3) is dischargeable through the discharge portion (30) to the setting tool (5), in particular to the setting head (7) of the setting tool (5).

16. A supply method using the supply device (1) according to one of the claims 1 to 13, comprising the steps:
a. supplying (step A) a joining element (3) to the receiving portion (10) of the supply device (1),
b. positioning (step B) the joining element (3) in front of the first opening (12) in the receiving portion (10) so that the joining element (3) is arranged in front of a flexible thrust element (40),
c. moving (step C) the thrust element (40) from a retracted state into an extended state, so that the joining element (3) which is positioned in front of the thrust element (40) is moved in the direction of the discharge portion (30) through the hose (20), preferably through a profile hose,
d. discharging (step D) the joining element (3) when it reaches the discharge portion and moving back the flexible thrust element (40) from the extended into the retracted position.

17. A setting method by using the supply device (1) according to one of the claims 1 to 13 in combination with claim 6, comprising the steps:
a. supplying (step a) a joining element (3) to the receiving portion (10) of the supply device (1),
b. positioning (step b) the joining element (3) in front of the first opening (12) in the receiving portion (10) so that the joining element (3) is arranged in front of a flexible thrust element (40),
c. moving (step c) the thrust element (40) from a retracted state into an extended state so that the joining element (3) which is positioned in front of the thrust element (40) is moved in the direction of the discharge portion (30) through the hose (20),
d. applying (step d) a torque on the joining element (3) by means of the transmission means (48) at the front end (42) of the thrust element (40) by means of a second drive means (70) when reaching the discharge portion (30) and thus setting the joining element (3) into at least one component with the thrust element (40) preferably transmitting a torque between 3 Nm and 30 Nm, particularly preferred up to 15 Nm.

## Revendications

1. Dispositif d'alimentation (1) pour éléments d'assemblage (3), comportant :
a. une zone de réception (10) destinée à au moins un élément d'assemblage (3), dans laquelle un élément d'assemblage (3) peut être reçu et positionné devant une première ouverture (12),
b. un tube (20) fermé circonférentiellement, constitué d'un matériau flexible, lequel est relié à la zone de réception (10) à une première extrémité (22) et à une zone de délivrance (30) à une deuxième extrémité (24) opposée,
**caractérisé par**
c. un élément de poussée (40) flexible, lequel peut être déplacé à travers le tube (20) selon un mouvement de va-et-vient, à l'aide d'un moyen d'entraînement (50), entre une position rétractée dans laquelle une extrémité avant (42) de l'élément de poussée (40) se trouve dans la zone de réception (10), et une position déployée dans laquelle l'extrémité avant (42) de l'élément de poussée (40) se trouve dans la zone de délivrance (30), de sorte que l'élément d'assemblage (3) positionné devant la première ouverture (12) peut être poussé au moyen de l'élément de poussée (40), depuis la zone de réception (10) vers la zone de délivrance (30), à travers le tube (20).

2. Dispositif d'alimentation (1) selon la revendication 1, dans lequel la zone de réception (10) comporte en outre un moyen d'individualisation (14) destiné à séparer un élément d'assemblage (3) d'une pluralité d'éléments d'assemblage (3) et à le positionner devant la première ouverture (12), de préférence un moyen mécanique.

3. Dispositif d'alimentation (1) selon l'une des revendications précédentes, dans lequel l'élément de poussée (40) comporte l'un des éléments suivants : une tige-ressort, de préférence une tige-ressort enroulée à spires jointives, une tige élastomère, une chaîne articulée, un câble en acier, un câble Bowden ou une tôle à ressort rigide à la pression.

4. Dispositif d'alimentation (1) selon l'une des revendications précédentes, dans lequel le tube (20) est un tube profilé et l'élément de poussée (40) comporte un dispositif de retenue (44) destiné à l'élément d'assemblage (3), adjacent à l'extrémité avant (42) de l'élément de poussée (40), en particulier une pièce de forme ou deux bras de retenue.

5. Dispositif d'alimentation (1) selon la revendication 4, dans lequel le dispositif de retenue (44) comporte une pièce de forme, laquelle
a. présente un contour extérieur conçu pour s'adapter à un contour de l'élément d'assemblage (3) et/ou à un contour intérieur du tube profilé (20), et/ou
b. se rétrécit à une extrémité tournée vers l'élément de poussée (40).

6. Dispositif d'alimentation (1) selon l'une des revendications 1 à 3, dans lequel l'élément de poussée (40) présente un moyen de transmission (48) adjacent à l'extrémité avant (42), lequel peut venir en prise avec une tête de l'élément d'assemblage (3), de sorte qu'une rotation de l'élément de poussée (40) peut être transmise à l'élément d'assemblage (3).

7. Dispositif d'alimentation (1) selon l'une des revendications précédentes, dans lequel, à l'état rétracté, l'élément de poussée (40) est au moins partiellement enroulé sur un tambour ou disposé dans un boîtier.

8. Dispositif d'alimentation (1) selon l'une des revendications précédentes, dans lequel l'élément de poussée (40) présente une section transversale comprise entre 30 et 80 % de la section transversale du tube (20), de préférence d'un tube profilé.

9. Dispositif d'alimentation (1) selon l'une des revendications précédentes, dans lequel le moyen d'entraînement (50) comporte un actionneur (52) électrique, pneumatique ou hydraulique.

10. Dispositif d'alimentation (1) selon l'une des revendications précédentes, dans lequel le moyen d'entraînement (50) comporte en outre deux roues (54, 56), entre lesquelles l'élément de poussée (40) est guidé et parmi lesquelles au moins l'une est entraînée.

11. Dispositif d'alimentation (1) selon la revendication 10, dans lequel
a. au moins l'une des deux roues (54, 56) présente un moletage, un revêtement élastomère ou une bague élastomère, de préférence les deux roues (54, 56), et/ou
b. une roue (56) est disposée de façon à être précontrainte en direction de l'autre roue (54), en particulier précontrainte par ressort.

12. Dispositif d'alimentation (1) selon l'une des revendications 10 ou 11, lequel comporte en outre au moins l'un des capteurs suivants : un capteur de déplacement, un capteur de force, un capteur de couple de rotation et/ou un capteur de vitesse.

13. Dispositif d'alimentation (1) selon l'une des revendications précédentes, dans lequel une longueur du tube (20) mesure au moins 50 cm, de préférence au moins 60 cm, et de façon particulièrement préférée au moins 70 cm.

14. Outil de pose (5) destiné à la pose d'un élément d'assemblage (3), dans lequel l'outil de pose (5) comporte un dispositif d'alimentation (1) selon l'une des revendications précédentes.

15. Outil de pose (5) selon la revendication 14, dans lequel la zone de délivrance (30) est disposée de façon adjacente à une tête de pose (7) de l'outil de pose (5) et la zone de réception (10) est disposée à distance de la tête de pose (7), de sorte que l'élément d'assemblage (3) peut être délivré à l'outil de pose (5), en particulier à la tête de pose (7) de l'outil de pose (5), par l'intermédiaire de la zone de délivrance (30).

16. Procédé d'alimentation utilisant le dispositif d'alimentation (1) selon l'une des revendications 1 à 13, comportant les étapes suivantes :
a. alimentation (étape A) d'un élément d'assemblage (3) vers la zone de réception (10) du dispositif d'alimentation (1),
b. positionnement (étape B) de l'élément d'assemblage (3) devant la première ouverture (12) dans la zone de réception (10), moyennant quoi l'élément d'assemblage (3) est disposé devant un élément de poussée (40) flexible,
c. déplacement (étape C) de l'élément de poussée (40) depuis un état rétracté vers un état déployé, moyennant quoi l'élément d'assemblage (3) positionné devant l'élément de poussée (40) est déplacé en direction de la zone de délivrance (30) à travers le tube (20), de préférence à travers un tube profilé,
d. délivrance (étape D) de l'élément d'assemblage (3) lorsque la zone de délivrance est atteinte, et renvoi de l'élément de poussée (40) flexible de la position déployée vers la position rétractée.

17. Procédé de pose au moyen du dispositif d'alimentation (1) selon l'une des revendications 1 à 13 en combinaison avec la revendication 6, comportant les étapes suivantes :
a. alimentation (étape a) d'un élément d'assemblage (3) vers la zone de réception (10) du dispositif d'alimentation (1),
b. positionnement (étape b) de l'élément d'assemblage (3) devant la première ouverture (12) dans la zone de réception (10), moyennant quoi l'élément d'assemblage (3) est disposé devant un élément de poussée (40) flexible,
c. déplacement (étape c) de l'élément de poussée (40) depuis un état rétracté vers un état déployé, moyennant quoi l'élément d'assemblage (3) positionné devant l'élément de poussée (40) est déplacé en direction de la zone de délivrance (30) à travers le tube (20),
d. application (étape d) d'un couple de rotation à l'élément d'assemblage (3) par l'intermédiaire du moyen de transmission (48) situé à l'extrémité avant (42) de l'élément de poussée (40), au moyen d'un deuxième moyen d'entraînement (70), lorsque la zone de délivrance (30) est atteinte, et de ce fait, pose de l'élément d'assemblage (3) dans au moins un composant, l'élément de poussée (40) transmettant de préférence un couple de rotation compris entre 3 Nm et 30 Nm, de façon particulièrement préférée jusqu'à 15 Nm.
